# NEW EUROPEAN PATENT SPECIFICATION

(11) **EP 3 754 729 B2**
(45) Date of publication and mention of the opposition decision: **03.06.2026**
(45) Mention of the grant of the patent: 20.12.2023
(21) Application number: 19754151.9
(22) Date of filing: 31.01.2019
(51) Int. Cl.: H01L 31/048, H01L 31/0725, H01L 31/0203, H01L 31/05, H01L 31/0224, H01L 31/036, H01L 31/18

(54) **SOLAR CELL MODULE COMPRISING PEROVSKITE SOLAR CELL AND MANUFACTURING METHOD THEREOF**
SOLARZELLENMODUL MIT PEROWSKITSOLARZELLE UND VERFAHREN ZU SEINER HERSTELLUNG
MODULE DE CELLULES SOLAIRES COMPRENANT UNE CELLULE SOLAIRE DE PÉROVSKITE ET SON PROCÉDÉ DE FABRICATION

(30) Priority: 14.02.2018 KR 20180018667; 02.04.2018 KR 20180038378; 30.05.2018 KR 20180062163
(43) Date of publication of application: 23.12.2020
(73) Proprietor: Trina Solar Co., Ltd, Changzhou, Jiangsu 213031 (CN)
(72) Inventor: LEE, Giwon, Seoul 08592 (KR); SHIM, Goo Hwan, Seoul 08592 (KR); YANG, Youngsung, Seoul 08592 (KR)
(74) Representative: Arnold & Siedsma
(86) International application number: PCT/KR2019/001407
(87) International publication number: WO 2019/160264

(56) References cited:
- EP-A1- 3 182 466
- CN-U- 207 009 453
- JP-A- 2007 073 745
- KR-A- 20120 114 395
- KR-A- 20150 043 872
- KR-A- 20150 100 145
- KR-A- 20170 112 971
- KR-A- 20180 007 585
- US-A1- 2009 078 250
- US-A1- 2011 036 390
- US-A1- 2011 048 536
- US-A1- 2012 024 376
- US-A1- 2013 146 129
- US-A1- 2015 053 258
- US-A1- 2016 013 329
- US-A1- 2016 254 402
- US-A1- 2016 315 209
- US-A1- 2016 315 581
- US-A1- 2017 149 005
- KEVIN A. BUSH ET AL: "23.6%-efficient monolithic perovskite/silicon tandem solar cells with improved stability", NATURE ENERGY, vol. 2, no. 4, 1 April 2017 (2017-04-01), pages 1 - 7, XP055583818, DOI: 10.1038/nenergy.2017.9
- Lei Shi: “Low cost encapsulations for perovskite solar cells”, DOI:https://doi.org/10.26190/unsworks/21016 - Dissertation University of New Wales – 29.03.2018
- ANONYMOUS: "International Technology Roadmap for Photovoltaic (ITRPV) Results 2017 including maturity report 2018; Ninthe edition", INTERNATIONAL TECHNOLOGY ROADMAP FOR PHOTOVOLTAIC (ITRPV), VDMA, 1 September 2018 (2018-09-01), pages 1 - 76, XP093226528, Retrieved from the Internet <URL:https://www.vdma.org/>
- ANONYMOUS: "DuPont™ Elvax® EVA resins for Adhesives, Sealants and Wax Blends", DUPONT DE NEMOURS INT’L. S.A., GENEVA, SWITZERLAND, Geneva, Switzerland, XP055542618, Retrieved from the Internet <URL:http://www.dupont.com/content/dam/dupont/products-and-services/packaging-materials-and-solutions/packaging-materials-and-solutions-landing/documents/elvax_adhesives_wax_blends.pdf> [retrieved on 20190115]
- Advances in Photovoltaics: Part 2, 1st Edition, Volume 89 edited by Gerhard P. Willeke and Eicke R. Weber, Chapter Four and the copyright page showing the year of publication (N10)
- LEI SHI, TREVOR L. YOUNG, JINCHEOL KIM, YUN SHENG, LEI WANG, YIFENG CHEN, ZHIQIANG FENG, MARK J. KEEVERS, XIAOJING HAO, PIERRE J. : "Accelerated Lifetime Testing of Organic–Inorganic Perovskite Solar Cells Encapsulated by Polyisobutylene", APPLIED MATERIALS & INTERFACES, AMERICAN CHEMICAL SOCIETY, US, vol. 9, no. 30, 2 August 2017 (2017-08-02), US , pages 25073 - 25081, XP055692593, ISSN: 1944-8244, DOI: 10.1021/acsami.7b07625

## Description

### [Technical Field]

Disclosed herein is a solar cell module including a perovskite solar cell and a manufacturing method thereof.

### [Background]

Solar cells are a type of an energy conversion element that can convert solar energy into electric energy, and are considered one of the commercial alternative energy sources.

Among the solar cells, crystalline silicon (c-Si) solar cells are a typical single-junction solar cell that is widely used as a commercial solar cell.

However, the crystalline silicon solar cell has low photoelectric conversion efficiency. Accordingly, research has been conducted into a tandem solar cell, for example, a perovskite solar cell including a perovskite layer, or single-junction solar cells which include absorbing layers with different band gaps and which are connected to constitute a solar cell.

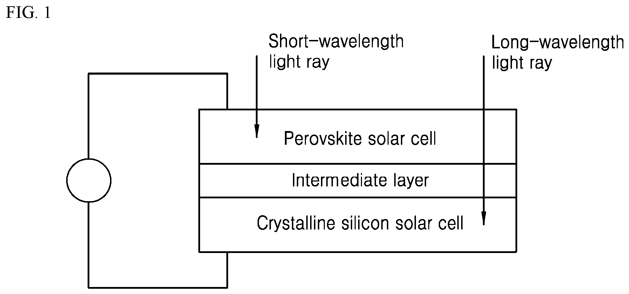

FIG. 1 is a schematic view illustrating a cross section of a 2-terminal tandem solar cell that is an ordinary form among tandem solar cells, and for the solar cell, a single-junction solar cell including an absorbing layer having a relatively high band gap and a single-junction solar cell including an absorbing layer having a relatively low band gap are bonded (a tunnel-junction), using an adhesive layer as a medium.

Among the tandem solar cells, a perovskite/crystalline silicon tandem solar cell, which uses the single-junction solar cell including an absorbing layer having a relatively high band gap as a perovskite solar cell, may ensure 30 % or higher of photoelectric conversion efficiency. Accordingly, the perovskite/crystalline silicon tandem solar cell has attracted much attention.

For a solar cell, a plurality of solar cells is electrically connected in series or in parallel and experience a packaging process to be used as a solar cell module.

This is because electromotive force generated in each solar cell is not enough to be used commercially.

A modulation process for manufacturing a solar cell module includes a tabbing step where a ribbon is bonded onto both surfaces of each solar cell, and a string step where the cells are mutually connected using the ribbon to from a string. Then an array step where the cells arranged in strings are positioned on an encapsulating material and the strings are electrically connected, a module setting step where the encapsulating material is covered with a back sheet, and a lamination step are performed.

The modulation process is generally performed at about 150 °C or higher to thermally cure the encapsulation material and the like.

A commercial crystalline silicon (c-Si) solar cell of the related art is not thermally degraded during the high temperature lamination process. Accordingly, the crystalline silicon (c-Si) solar cell has no problem in the high-temperature process.

However, a highly efficient perovskite solar cell or a tandem solar cell including a perovskite solar cell includes a perovskite absorbing layer. The perovskite absorbing layer exhibits instability in heat and moisture.

Accordingly, when a modulation process and material of the related art is applied to a perovskite solar cell or a tandem solar cell including the perovskite solar cell, the perovskite absorbing layer is thermally degraded, causing deterioration of performance and reliability of the solar cell.

Particularly, a high-temperature soldering process in the tabbing step included in the manufacturing method of a crystalline silicon solar cell module of the related art can no longer be applied to a manufacturing method of a solar cell including a perovskite absorbing layer.

In the tabbing step, alignment between busbar electrodes and ribbons is an important factor for determining a yield in a solar cell module processing. In case the busbar electrodes are not aligned with the ribbons, charge carries generated in the solar cell may not be efficiently collected, and a surface of a lower portion of the ribbon cannot absorb sunlight and an active surface area is reduced, thereby deteriorating photoelectric conversion efficiency.

There is a growing need for improvement in photoelectric conversion efficiency of a solar cell for the module as well as the solar cell.

In recent years, efforts to improve photoelectric conversion efficiency of a solar cell module have been made by preventing a reduction in an active surface area of the module as much as possible. As part of an effort to improve photoelectric conversion efficiency, a linewidth of a busbar electrode continues to be reduced. Thus, the busbar electrode and a ribbon need to be accurately aligned.

Required are technologies for maximizing a surface area capable of absorbing light rays in a solar cell module and transporting charge carriers collected in a solar cell with lower resistance outwards. The technologies are important to improve productivity in a modulation process and photoelectric conversion efficiency of the solar cell module, thereby contributing to commercialization of a solar cell and expansion of a market for the solar cell.

In the tandem solar cell of FIG. 1, a texture structure is generally formed on a surface of a crystalline silicon substrate to reduce reflectivity of incident light, such that photoelectric conversion efficiency of the solar cell improves. In case the texture structure is formed at a lower portion of the tandem solar cell, a perovskite solar cell cannot be evenly deposited.

The texture structure is generally a few to dozens of µm thick, while a unit layer is dozens to hundreds of nm thick. Each unit layer experiences a conformal growth, maintaining a shape of a substrate or a unit layer under the unit layer. In case the substrate or the lower layer has a texture, the unit layer is hardly formed uniformly at a peak of the texture due to the Gibbs-Thomson effect.

A small-sized substrate has been used such that a perovskite solar cell is uniformly deposited on the textured substrate. In this case, although uniform deposition can be ensured, productivity is significantly reduced. Accordingly, in relation to manufacturing a solar cell module using a perovskite solar cell or a tandem solar cell including the perovskite solar cell, required are a solar cell module and a manufacturing method thereof that can ensure unit layers having excellent uniformity and high productivity, and can prevent damage to a perovskite absorbing layer, caused due to a high-temperature processing.

As a related art, a tabbing method and apparatus and the like in a modulation process of a solar cell are disclosed in Korean Patent No. 10-1305087 (registered on September, 10, 2013 ).CN 207 009 453 U discloses a perovskite solar cell 3, a first encapsulating material 4 and a second encapsulating material 2 configured to seal the solar cell, a first protective member 5 disposed on the first encapsulating material, a second protective member disposed on the second encapsulating material, and a third encapsulating material 2 disposed on lateral surfaces of the first encapsulating material and disposed between the first protective member and the second protective member. The document " 23.6%-efficient monolithic perovskite/silicon tandem solar cells with improved stability" by Kevin A. Bush et al.; XP055583818 discloses 23.6%-efficient monolithic perovskite/silicon tandem solar cells.US 2016/315209 A1 provides a double-glass photovoltaic cell module, and the double-glass photovoltaic cell module improves output power of a photovoltaic module, and has favorable weather resistance, a long service life, high ultraviolet absorbance, good stability, and high security.US 2009/078250 A1 discloses a method of manufacturing a solar cell module which includes a plurality of solar cells sealed with a sealing member between a first protective member and a second protective member, the sealing member including a first sealing member having a first melting point and a second sealing member having a second melting point higher than the first melting point.US 2016/254402 A1 provides a sheet set for encapsulating a solar cell which is disposed between a light-receiving surface side protective member and a back surface side protective member, and is used for encapsulating a solar cell element and a wiring material. The sheet set for encapsulating a solar cell includes a first encapsulating material sheet disposed on a light-receiving surface side and a second encapsulating material sheet disposed on a back surface side.US 2012/024376 A1 discloses a method for producing a resin composition for solar cell sealing material. The method for producing the resin composition for solar cell sealing material includes the step of preparing an ethylene-vinyl acetate copolymer containing a vinyl acetate unit in an amount of 25 to 35 wt % and a crosslinking agent.

### [Disclosure]

### [Technical Problems]

The present invention is directed to a solar cell module as defined by the subject-matter of the claims.

### [Technical Solutions]

According to the present disclosure, a solar cell is defined by the subject-matter of claim 1, which may prevent thermal degradation and/or damage to a perovskite absorbing layer, may prevent deterioration of performance of the solar cell module and may improve reliability of the solar cell module.

According to an example useful for understanding the invention but not covered by the scope of the claims, manufacturing method of a solar cell module, by which no high-temperature pre-processing is needed, damage to the solar cell may be prevented using a low-temperature lamination process, a lamination process and a soldering process may be carried out at the same time, and failure of the module may be prevented by accurately aligning busbar electrodes and interconnectors, may include: an alignment step of aligning each corresponding interconnector on an electrode of each solar cell including a perovskite layer; a temporary fixation step of temporarily fixing the conductive interconnectors on the solar cells; a string step of the conductive interconnector's arranging a plurality of the temporarily fixed solar cells and forming a string; a lay-up step of arranging the solar cell string between the encapsulating materials; and a low-temperature lamination step of allowing the arranged solar cells to cohere at 150 °C or lower through a laminator and electrically bonding the interconnectors onto the solar cell.

According to an example useful for understanding the invention but not covered by the scope of the claims, a solar cell module, which may prevent a reduction in an active surface area as much as possible, thereby reducing defects of an exterior and preventing a reduction in short-circuit current, may include: a plurality of solar cells including a perovskite layer, a first electrode and a second electrode; a plurality of interconnectors configured to electrically connect a first electrode and a second electrode of adjacent cells among the plurality of solar cells; and an electro-conductive adhesive layer disposed at boundaries between the electrodes and the interconnectors.

According to an example useful for understanding the invention but not covered by the scope of the claims, a solar cell module, which may prevent a reduction in an active surface area as much as possible, thereby reducing defects of an exterior and preventing a reduction in short-circuit current, may include: a plurality of solar cells including a perovskite layer, a first electrode and a second electrode; a plurality of interconnectors configured to electrically connect a first electrode and a second electrode of adjacent cells among the plurality of solar cells; and an adhesive tape layer formed on the interconnectors in direction across the interconnectors.

According to an example useful for understanding the invention but not covered by the scope of the claims, a manufacturing method of a tandem solar cell module, by which uniformity and productivity of unit layers, constituting an upper solar cell including a perovskite absorbing layer, may be ensured, may include: a step of disposing lower-solar-cell unit layers constituting a lower solar cell on a substrate; a step of disposing an intermediate layer on the lower solar cell; and a step of disposing upper-solar-cell unit layers constituting an upper solar cell including a perovskite absorbing layer on the intermediate layer, and may further include a scribing step of dividing the substrate into any size of mini-cells in any of the steps of disposing unit layers constituting the upper solar cell.

According to an example useful for understanding the invention but not covered by the scope of the claims, a manufacturing method of a tandem solar cell module, by which uniformity and productivity of unit layers, constituting an upper solar cell including a perovskite absorbing layer, may be ensured, may include: a step of disposing lower-solar-cell unit layers constituting a lower solar cell on a substrate; a step of disposing an intermediate layer on the lower solar cell; a step of disposing upper-solar-cell unit layers constituting an upper solar cell including a perovskite absorbing layer on the intermediate layer; and a scribing step of dividing the substrate into any size of mini-cells after disposing the upper solar cell, and may further include a masking step of forming a mask between the mini-cells on the substrate in any of the steps of disposing unit layers constituting the upper solar cell.

### [Advantageous Effects]

A solar cell module according to the present disclosure may be manufactured using a low-temperature encapsulating material and a low-temperature processing that may prevent thermal degradation and/or damage.

Accordingly, the solar cell module may not cause deterioration of conversion efficiency of a solar cell, thereby improving efficiency of the module.

For the solar cell module, a new structure and a new material of an encapsulating material may be adopted, thereby ensuring a very low water vapor transmission rate of the solar cell module.

Accordingly, the solar cell module may prevent degradation of a solar cell, caused by moisture, thereby improving reliability of the module.

In a manufacturing method of a solar cell module according to the present disclosure, no high-temperature pre-processing is needed, and a low-temperature lamination process may be applied, thereby preventing thermal damage or degradation of a solar cell. Thus, the solar cell module according to the disclosure may not cause deterioration of photoelectric conversion efficiency of the solar cell and may maintain excellent photoelectric conversion efficiency of the module.

In the manufacturing method of a solar cell module, a lamination process and a soldering process may be performed at the same time. As a result, tact time for the solar cell module may be shortened, thereby improving productivity.

In the manufacturing method of a solar cell module, electrodes and interconnectors may be accurately aligned, thereby preventing failure in the module and improving yields and productivity. Additionally, a reduction in an active surface area of a solar cell, caused by misalignment, may be prevented, thereby improving photoelectric conversion efficiency of the solar cell module.

In the solar cell module and the manufacturing method thereof, loss in an active surface area of a solar cell may not occur except electrodes and interconnectors, thereby reducing a defect of an exterior of the solar cell module and preventing a reduction in short-circuited current.

According to the present disclosure, uniformity of each unit layer of a solar cell constituting the solar cell module may be ensured, and productivity may increase unlike a solar cell processing of the related art, thereby ensuring improvement in efficiency of a tandem solar cell module and significant improvement in productivity of the tandem solar cell module.

### [Description of Drawings]

- FIG. 1 is a schematic cross-sectional view illustrating an ordinary solar cell module including a solar cell module according to the present disclosure.
- FIG. 2 is a schematic perspective view illustrating a solar cell module of the related art.
- FIG. 3 is a cross-sectional view cut along line II-II in FIG. 3.
- FIG. 4 is a schematic cross-sectional view illustrating a solar cell module according to an aspect of an embodiment.
- FIG. 5 is a schematic cross-sectional view illustrating an embodiment of a solar cell module where a frame is installed at the solar cell module in FIG. 4.
- FIG. 6 is a perspective view illustrating an example, useful for understanding the invention but not covered by the scope of the claims, of a solar cell module where a frame is installed at the solar cell module in FIG. 4.
- FIG. 7 is a perspective view illustrating yet another example, useful for understanding the invention but not covered by the scope of the claims, of a solar cell module where a frame is installed at the solar cell module in FIG. 4.
- FIG. 8 is a schematic flow chart illustrating a manufacturing method of a solar cell module according to an example useful for understanding the invention but not covered by the scope of the claims.
- FIG. 9 is a cross-sectional view illustrating a solar cell and a solar cell module according to an example useful for understanding the invention but not covered by the scope of the claims.
- FIG. 10 is a schematic flow chart illustrating a manufacturing method of a solar cell module according to an example useful for understanding the invention but not covered by the scope of the claims.
- FIG. 11 is a view illustrating a state where interconnectors, aligned using a temporary fixation tape, are temporarily fixed in a temporary fixation step according to an example useful for understanding the invention but not covered by the scope of the claims.
- FIG. 12 is a view illustrating a state where interconnectors, aligned by discontinuously applying an electro-conductive adhesive, are temporarily fixed according to an example useful for understanding the invention but not covered by the scope of the claims.
- FIG. 13 is a view illustrating a state where interconnectors, aligned by applying an electro-conductive adhesive 8 consecutive times, are temporarily fixed according to an example useful for understanding the invention but not covered by the scope of the claims.
- FIG. 14 is a view illustrating a state where interconnectors aligned using an electro-conductive adhesive are laminated and connected according to an example useful for understanding the invention but not covered by the scope of the claims.
- FIG. 15 is a view illustrating interconnectors having different cross sections.
- FIG. 16 is a view illustrating a binary state of silver (Ag) and antimony (Sb).
- FIG. 17 is a view illustrating a binary state of silver (Ag) and tin (Sn).
- FIG. 18 is a view illustrating an example, useful for understanding the invention but not covered by the scope of the claims, where a solar cell, constituting a solar cell module including a perovskite absorbing layer according to the present disclosure, is formed in the module.
- FIG. 19 is a view illustrating another example, useful for understanding the invention but not covered by the scope of the claims, where a solar cell, constituting a solar cell module including a perovskite absorbing layer according to the present disclosure, is formed in the module.
- FIG. 20 is a cross-sectional view illustrating a mask formed at a boundary between mini-cells for forming a solar cell module in a mother substrate of the module.

### [Detailed Description]

Below, a solar cell module including a perovskite solar cell and a manufacturing method thereof according to an aspect of preferred embodiments are described with reference to the accompanying drawings.

The present disclosure is not intended to limit the embodiments set forth herein. These embodiments may be modified in many different forms, and may be provided as examples so that the present disclosure may be thorough and complete and that the scope of the disclosure will be fully conveyed to one having ordinary skill in the art to which the disclosure pertains.

To make the disclosure clear, description not related to the disclosure may be omitted, and identical or similar components are denoted by identical reference numerals throughout the specification. Further, some embodiments of the present disclosure are described in detail with reference to the exemplary drawings. In giving reference numerals to the components in each drawing, the same components may be given the same reference numeral as possible even when they are illustrated in different drawings. Further, in the present disclosure, detailed description of related known configurations or functions is omitted if it is deemed to make the gist of the present disclosure unnecessarily vague.

Terms such as first, second, A, B, (a), (b) and the like may be used herein when describing components in the present disclosure. These terms are intended to distinguish one component from another component, and the essence, order, sequence, or number and the like of the components is not limited by these terms. Additionally, when any one component is described as being "connected," "coupled," or "connected" to another component, they may be connected or coupled to each other directly, or an additional component may be "interposed" between them, or they may be "connected," "coupled," or "connected" through an additional component.

Further, in implementing features of the present disclosure, the features may be described as being performed by separate components for convenience of description. However, they may be implemented by a single device or module, or a feature may be implemented by several devices or modules.

### <First Embodiment>

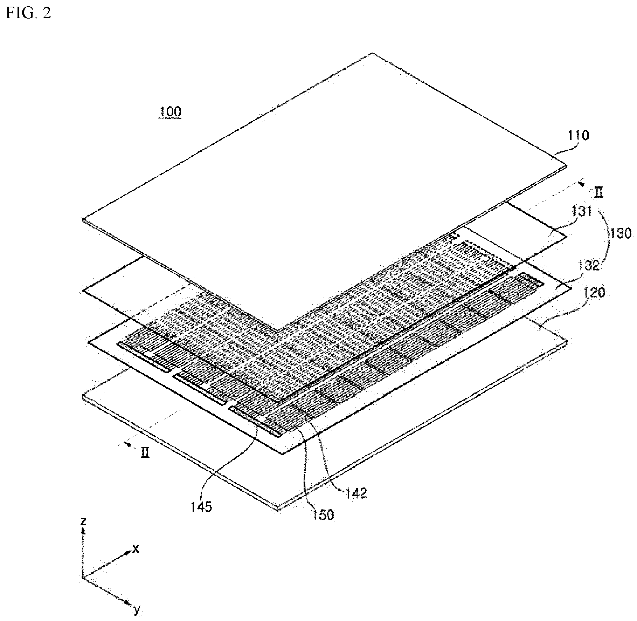

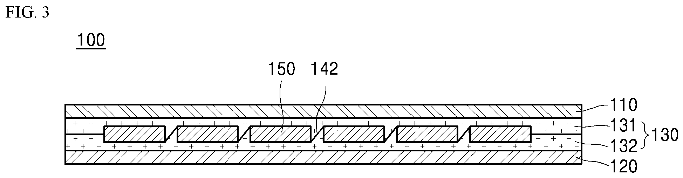

FIG. 2 is a perspective view illustrating a solar cell module of the related art, and FIG. 3 is a cross-sectional view cut along line II-II in FIG. 3.

Referring to FIGS. 2 and 3, a solar cell module 100 may include a plurality of solar cells 150 and an interconnector 142 configured to electrically connect the plurality of solar cells 150. Additionally, the solar cell module 100 may include an encapsulating material 130 including a first encapsulating material 131 and a second encapsulating material 132 that surround and seal the plurality of solar cells 150 and the inter connector 142 configured to connect the plurality of solar cells 150, a first protective member 110 positioned on a first surface of the solar cell 150 on the encapsulating material 130 and a second protective member 120 positioned on a second surface of the solar cell 150 on the encapsulating material 130.

In this case, the first protective member 110 and the second protective member 120 may be made of an insulating material that may protect the solar cell 150 from an external impact, moisture, ultraviolet rays and the like.

The first protective member 110 is made of a light transmitting material that is light permeable, and the second protective member 120 is implemented as a sheet made of a light transmitting material or a reflective material.

For example, the first protective member 110 may be implemented as a glass substrate and the like, and the second protective member 120 may be a TPT(Tedlar/PET/Tedlar)-type one, or may include a poly vinylidene fluoride (PVDF) resin layer formed on at least one surface of a glass film, a metallic film such as an aluminum film and the like or a base film (e.g., polyethyleneterephthalate (PET)).

In this case, the so-called white glass, which has a lower iron (Fe) content to improve transmittance of sunlight, particularly, sunlight in a wavelength range between 380 to 1,100 nm, may be generally used as the first protective member 110. Additionally, when necessary, glass for the first protective member 110 may be tempered to protect the solar cell 150 from an external impact or a foreign substance.

When the first, and second protective members are all made of a transparent material, both of their surfaces may receive light, thereby ensuring an increase in power generation.

According to the present disclosure, the plurality of solar cells 150 may be connected by the interconnector 142 electrically in series, parallel or series-parallel. The present disclosure is not intended to limit an electric connection method. The interconnector 142 and the solar cell 150 are specifically described below.

A bus ribbon 145 may be connected by the interconnector 142 and may alternately connect both ends of the interconnectors 142 of the solar cells 150 forming a single column (i.e., solar cell strings). The bus ribbon 145 may be disposed at an end of the solar cell string in a direction across the solar cell string.

Referring to FIGS. 2 and 3, the encapsulating material 130 may include the first encapsulating material 131 positioned on the first surface and the second encapsulating material 132 positioned on the second surface of the solar cells 150 connected by the interconnector 142.

The first encapsulating material 131 and the second encapsulating material 132 may prevent moisture and air from coming into the solar cell 150, and may chemically bond components of the solar cell module 100. Accordingly, the first and second encapsulating materials 131, 132 necessarily require an insulating material having light transmittance and adhesion.

For example, ethylene-vinyl acetate copolymer (EVA) resin, polyvinylbutyral, silicone resin, ester-based resin and the like may be used as the first and second encapsulating materials 131, 132.

Among them, ethylene-vinyl acetate copolymer (EVA) resin has been used as the first and second encapsulating materials 131, 132 in the related art.

EVA resins may transmit sunlight such as ultraviolet (UV) rays having short wavelengths unlike other ingredient-based resins in addition to a softening point and strength similar to those of other ingredient-based resins. The EVA resins with a high light transmittance have been widely used as an encapsulating material of a solar cell module.

However, the EVA resins need to be process at a higher temperature than other resins. Additionally, the EVA resins may not have moisture permeability lower than that of other resins.

Due to the above-described properties of the EVA resins, the EVA resins are hardly used as an encapsulating material of a solar cell module including a perovskite absorbing layer described in the disclosure. Additionally, the perovskite absorbing layer is vulnerable to heat and moisture. In case a solar cell module including a perovskite absorbing layer continues to be exposed to heat and moisture, reliability of the solar cell module may be greatly deteriorated.

Structures and materials of the solar cell module in FIGS. 2 and 3 may not be applied to the solar cell module including a perovskite solar cell according to the present disclosure.

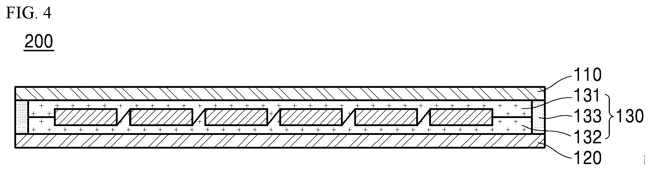

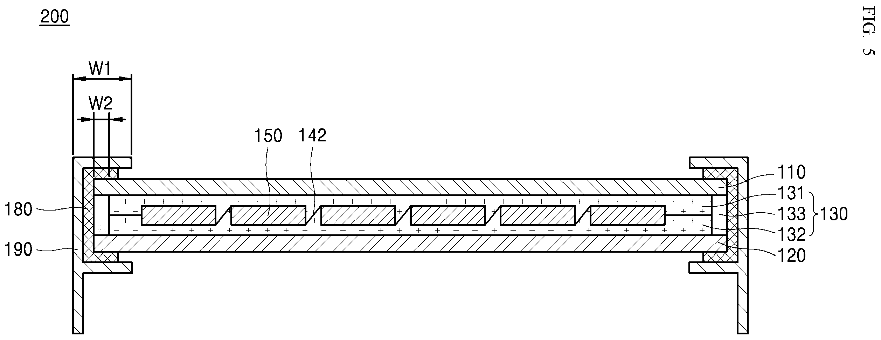

FIGS. 4 and 5 are a cross-sectional view or a perspective view illustrating a solar cell module according to an aspect of an embodiment.

As illustrated in FIG. 4, unlike the solar cell module 100 of the related art, the solar cell module 200 in the disclosure may further include a third encapsulating material 133 in addition to the first encapsulating material 131 and the second encapsulating material 132 in its structure.

Regarding properties of materials, in the invention the first encapsulating material 131 is placed on a light receiving surface, such that the first encapsulating material 131 needs to have higher light transmittance or higher light transmission than the second encapsulating material 132. Among materials having light transmittance, ethylene-vinyl acetate copolymer (EVA) resin, polyvinylbutyral, silicone resin, ester-based resin, olefin-based resin and the like may be used for the first encapsulating material 131.

Among the above materials, ethylene-vinyl acetate copolymer (EVA) resin or olefin-based resin may be used as a material for the first encapsulating material 131 of the solar cell module including a perovskite solar cell according to the present disclosure. For example, ethylene-vinyl acetate copolymer (EVA) resin is preferable over olefin-based resin as a material for the first encapsulating material 131 according to the disclosure because the EVA resin has a property of UV transmittance and has high transmittance in a range of short-wavelength visible light rays. The solar cell including a perovskite absorbing layer in the disclosure may have higher absorption of visible light rays in a range of short wavelengths than a crystalline silicon solar cell of the related art, thereby ensuring excellent photoelectric conversion efficiency.

The EVA resin where vinyl acetate (VA) is randomly mixed with low density polyethylene (LDPE), which is olefin-based resin, may form a polymer main chain. Accordingly, the EVA resin may basically have a property of LDPE, and its basic property may be determined based on content of VA.

In general, an increase in content of VA may result in an increase in optical transparency of the EVA resin and a decrease in crystallinity or a melting point or a softening point. An increase in content of the VA may cause a decrease in a water vapor transmission rate (WVTR) of the EVA resin.

A softening point and a WVTR as well as optical transparency are important factors for the solar cell including a perovskite absorbing layer in the present disclosure.

As the solar cell in the disclosure has a perovskite absorbing layer, a temperature during a module processing (e.g., a lamination processing) may be below 150 °C and preferably, below 100°C.

According to the disclosure, a minimum content of the VA in the EVA resin as the first encapsulating material may be determined by a maximum WVTR and a maximum processing temperature. When the EVA resin is used for the first encapsulating material, a minimum content of the VA in the EVA resin needs to be 10 wt.% or higher. In case the minimum content of the VA in the EVA resin is less than 10 wt.%, the EVA resin as the first encapsulating material may have an excessively low light transmittance and an excessively high processing temperature. In this case, the EVA resin is inappropriate for the first encapsulating material.

An excessively large content of the VA in the EVA resin may result in an excessively high WVTR of the EVA resin.

As the solar cell module is generally installed in the outside or an outdoor space, the solar cell module continues to be exposed to moisture. As the solar cell module according to the present disclosure includes a perovskite absorbing layer vulnerable to moisture as well as heat, the encapsulating material 130 of the solar cell module has to have a low WVTR. Accordingly, a maximum amount of the VA in the EVA resin as the first encapsulating material in the disclosure is 30 wt.% or lower. In case more than 30 wt.% of the VA is included, the WVTR of the first encapsulating material may be more than 30 g/(m2 •day), thereby increasing the possibility that the solar cell module is exposed to moisture.

In case the second protective member 120 is made of a material having no light transmittance, the second encapsulating material 132 in the disclosure doesn't need to have the property of UV transmittance unlike the first encapsulating material 131. Thus, the second encapsulating material 132 in the solar cell module according the present disclosure may be designed more freely in relation to light transmittance than the first encapsulating material 131.

Thanks to the above-described optical freedom of the second encapsulating material 132 in the disclosure, olefin-based resin may be used for the second encapsulating material 132 in the solar cell module according to the disclosure. Olefin-based resin may denote a resin such as polyethylene (PE) or polypropylene (PP) where a single double bond between carbons is included while carbons are bonded in the form of a chain.

However, the second encapsulating material 132 in the disclosure also needs to have a low module processing temperature and a low WVTR like the first encapsulating material 131. The second encapsulating material 132 may have a lower WVTR and processing temperature than the first encapsulating material 131 as the second encapsulating material 132 may be given freedom of material in relation to light transmittance.

Additionally, in case olefin-based resin is used for the second encapsulating material 132 in the disclosure, a processing temperature and a WVTR may be differently adjusted on the basis of ingredients and properties such as density and the like. For example, as high density polyethylene (HDPE) usable for the second encapsulating material 132 in the disclosure has a higher softening point than low density polyethylene (LDPE) usable for the second encapsulating material 132, a processing temperature may increase. However, as high density polyethylene (HDPE) has higher density than low density polyethylene (LDPE), high density polyethylene (HDPE) has a lower WVTR than low density polyethylene (LDPE). Accordingly, high density polyethylene (HDPE) and low density polyethylene (LDPE) have a tradeoff relationship.

Preferably, the second encapsulating material 132 according to the present disclosure may have a WVTR of 0.5 to 10 g/(m2 •day) considering a processing temperature, and more preferably, may have a WVTR of 0.7 to 4.5 g/(m2 •day).

From a structure perspective, the solar cell module 200 according to the disclosure may further include a third encapsulating material 133, unlike the solar cell module 100 of the related art.

The solar cell module, as described above, is generally installed in the outside or an outdoor space. Accordingly, the solar cell module continues to be exposed to moisture. In the solar cell module 100 of the related art, moisture may be structurally induced form the outside along a boundary between the first encapsulating material 131 and the second encapsulating material 132. Further, the induced moisture may not escape from the solar cell module 100 due to a sealing structure of the solar cell module 100.

In addition to the above problems of the solar cell module 100 of the related art, a problem of the solar cell module 200 according to the disclosure has to be solved. The problem is that coherence or rigidity between the first encapsulating material 131 and the second encapsulating material 132 is hardly ensured because the solar cell module 200 has to be processed at a low temperature. Thus, the solar cell module 200 according to the disclosure may further include a third encapsulating material 133 unlike the solar cell module 100 of the related art.

The third encapsulating material 133 according to the present disclosure may surround boundaries of the first encapsulating material 131 and the second encapsulating material 132 and may be placed between the first protective member 110 and the second protective member 120.

The third encapsulating material 133 in the solar cell module 200 according to the disclosure is less closely involved in absorption of sunlight of the solar cell than the first encapsulating material 131 and the second encapsulating material 132. Accordingly, while the third encapsulating material 133 needs no light transmittance, the third encapsulating material 133 needs to have a WVTR as low as possible.

To ensure a low WVTR, butyl rubber may be used for the third encapsulating material 133 in the disclosure. The butyl rubber itself may have no crack and may remain stable in a wide range of temperatures, and may exhibit rubber elastic properties. Accordingly, the butyl rubber may protect the solar cell module mechanically from an external impact, and may have high resistance against chemicals such as acids and alkalis. Additionally, the butyl rubber may excellently adhere to glass or metal used for the first protective member 110 and the second protective member 120 of the solar cell module 200 according to the disclosure.

When the third encapsulating material 133 of the solar cell module according to the present disclosure is made of the butyl rubber, the third encapsulating material 133 may have a very low WVTR of less than 0.01 g/(m2 •day), for example, 0.001 to 0.01 g/(m2 •day). The WVTR of the third encapsulating material 133 may be not only lower than that of the first encapsulating material 131 and but also lower than that of the second encapsulating material 132 having a WVTR lower than that of the first encapsulating material 131.

As illustrated in FIG. 5, the solar cell module 200 according to the disclosure may further include a frame 190 having a shape that surrounds the third encapsulating material, when necessary.

The frame according to the present disclosure may be disposed at edges of the solar cell module and may mechanically prevent an impact and stress applied to the module from each edge. The frame may also serve as a supporter when the solar cell module is installed.

Further, an additional edge sealant 180 may be further disposed between the frame 190 and the solar cell module 200.

The edge sealant 180 according to the present disclosure may prevent moisture or a foreign substance from permeating between the frame 190 and the solar cell module 200 to protect the solar cell module. Accordingly, the edge sealant 180 may be made of a material the same as a material of the third encapsulating material 133 or made of a material such as silicone resin capable of preventing permeation of moisture and the like.

According to the present disclosure, a width (W1) of the frame in a direction of a flat surface of the solar cell may be wider than a width (W2) of the third encapsulating material 133. When the width (W1) of the frame is wider than the width (W2) of the third encapsulating material, the frame may protect the solar cell module 200 from an impact and stress applied to the solar cell module from the outside more effectively.

A maximum of the width (W1) of the frame may be determined such that the frame does not cover the solar cell of the solar cell module. In case the width (W1) of the frame is too wide, the frame may cover the solar cell and the solar cell module may have lower efficiency.

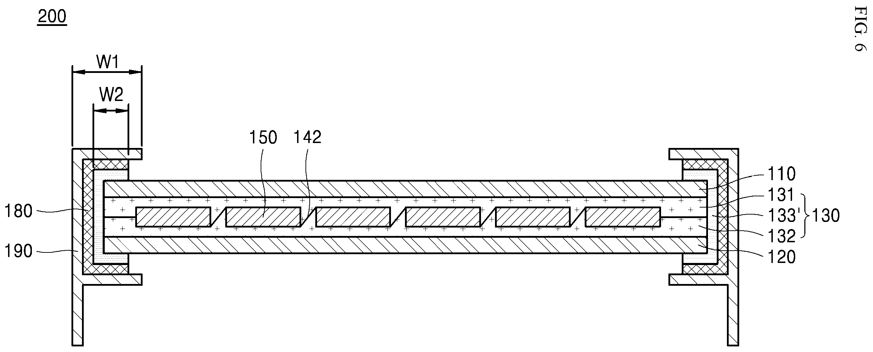

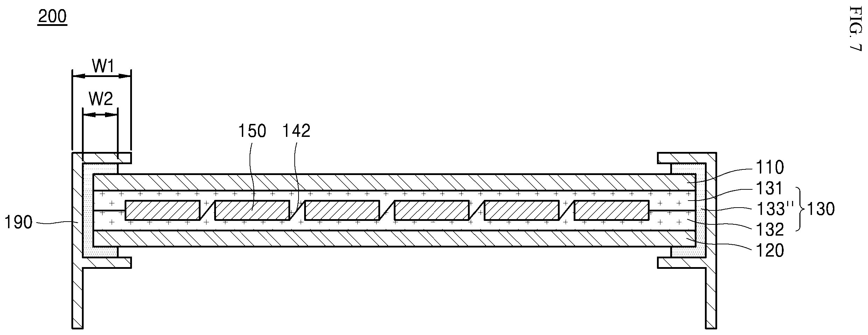

FIGS. 6 and 7 illustrate various embodiments of a structure and an arrangement of the third encapsulating material and the edge sealant in the solar cell module according to the present disclosure.

The third encapsulating material 133' in the embodiment of FIG. 6 may have a different shape from the third encapsulating material in the embodiment of FIG. 5.

The third encapsulating material 133' in FIG. 6 may have a shape that covers cover lateral surfaces of the first protective member 110 and the second protective member 120 as well as lateral surfaces of the first encapsulating material 131 and the second encapsulating material 132. Further, the third encapsulating material 133' in FIG. 6 may have a shape that contacts and protects parts of flat surfaces of the first protective member 110 and the second protective member 120.

The third encapsulating material 133" in the embodiment of FIG. 7 may have a similar shape to the third encapsulating material 133' in the embodiment of FIG. 6. The solar cell module in FIG. 7 does not include an additional edge sealant 180. Accordingly, in the solar cell module in FIG. 7, the third encapsulating material 133" may serve as the edge sealant. Thus, the solar cell module may have a simpler configuration.

In the solar cell module of FIG. 7, the third encapsulating material 133" may be thicker than in the solar cell module of FIG. 6 to definitely prevent permeation of moisture and the like.

In all the embodiments of FIGS. 5 to 7, the width (W1) of the frame 190 in the direction of the flat surface of the solar cell may be wider than the width (W2) of the third encapsulating materials 133, 133', 133" regardless of the shapes of the third encapsulating materials 133, 133', 133".

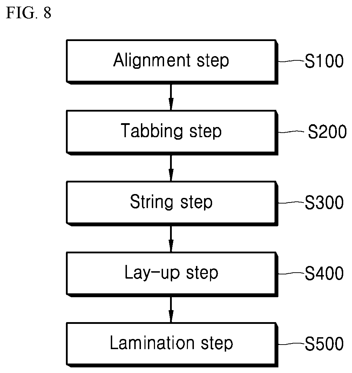

FIG. 8 is a schematic flow chart illustrating a manufacturing method of a solar cell module according to the present disclosure.

As illustrated in FIG. 8, corresponding interconnectors may be aligned respectively on each electrode of solar cells graded on the basis of their efficiency and colors in a cell test (S 100).

For each of the classified solar cells, the interconnector is bonded to both surfaces including a light receiving surface and a surface opposite to the light receiving surface, in a tabbing step (S200). In this case, when the interconnector is connected and bonded to a busbar electrode and then the interconnector is heated, a soldering alloy layer of the interconnector may be melted, and the interconnector and the busbar electrode may be soldered.

Then the interconnector may connect each of the solar cells bonded in a string step (S300) and a lay-up step (S400) in series to form a string. The solar cell string may be placed among the encapsulating materials 131, 132, 133 on the first protective member 110 and the second protective member 120 in a plurality of columns, and the strings may be electrically connected.

In a lamination step (S500), the strings covered by the encapsulating materials may be compressed and heated in a vacuum state at high enough temperature, and the first protective member, the encapsulating material, the solar cell, the encapsulating material and the second protective member are fixed.

A modulation process of the solar cell module according to the present disclosure may be performed as described above.

The first encapsulating material 131 according to the present disclosure may ensure a low processing temperature relative to EVA resin of the related art by adjusting content of VA. The second encapsulating material 132 according to the disclosure, which includes olefin-based resin, may ensure a low processing temperature. Further, the solar cell module 200 according to the disclosure, which further includes the third encapsulating material 133 structurally, may ensure a low WVTR.

For the solar cell module according to the disclosure, the improvement in a material and structure may help achieve excellent adhesion and a low WVTR at a processing temperature lower than 150 °C in the lamination step (S 500).

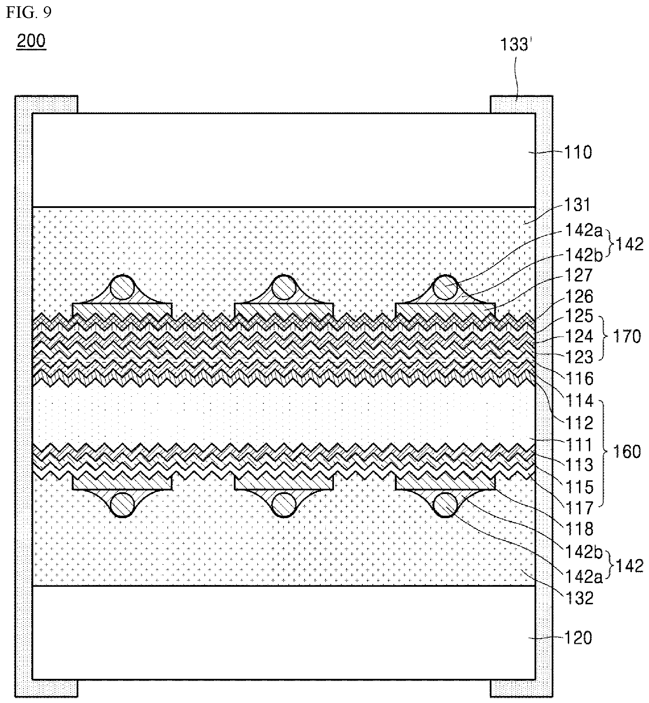

FIG. 9 is a cross-sectional view illustrating a solar cell and a solar cell module manufactured using the manufacturing method of a solar cell module according to the present disclosure.

In this specification, a tandem solar cell is illustrated as a cell of the solar cell module according to the disclosure for convenience of description, but not limited. As described above, a single junction solar cell such as a perovskite solar cell, or a tandem solar cell where the single junction solar cells are bonded using an intermediated layer may all be used as the solar cell according to the disclosure.

In FIG. 9, a 2-terminal tandem solar cell 150 having a structure, where a perovskite solar cell 170 including an absorbing layer with a relatively high band gap, and a silicon solar cell 160 including an absorbing layer with a relatively low band gap are directly bonded (a tunnel junction) using an intermediate layer 116 (also referred to as "tunnel junction layer", "intermediate layer" and "inter-layer") as a medium, is illustrated as the tandem solar cell.

Accordingly, light rays in a range of short wavelengths among light rays incident to the tandem solar cell 150 may be absorbed into the perovskite solar cell 120 disposed at an upper portion of the tandem solar cell and may generate charges, and light rays in a range of long wavelengths among the light rays incident to the tandem solar cell 150 may pass through the perovskite solar cell 120, may be absorbed into a crystalline silicon solar cell 110 disposed at a lower portion of the tandem solar cell and may generate charges.

As light rays in the range of long wavelengths may be absorbed into the crystalline silicon solar cell 160 disposed at the lower portion of the tandem solar cell to generate power, a threshold wavelength may move to the long wavelength, thereby expanding a rage of wavelengths absorbed by the entire solar cells.

When necessary, the intermediate layer 116 may be inserted between the crystalline silicon solar cell 160 and an electron transporting layer 123 for movement of charges. In this case, the intermediate layer 116 may also be inserted between the silicon solar cell 160 and the electron transporting layer 123 for movement of electrons when necessary. In this case, the intermediate layer 116 may be implemented using a transparent conductive oxide, a carbonaceous conductive material or a metallic material such that long-wavelength light rays passing through the perovskite solar cell 170 is incident on the silicon solar cell 160 disposed at the lower portion of the tandem solar cell without transmission loss. Additionally, an n-type material or a p-type material may be used as a doping material and may be doped for the junction layer 116.

To reduce reflectivity of incident light on a surface of the single junction solar cell and to increase paths of light incident to the solar cell, a text structure is generally applied to the surface. Accordingly, a texture may also be formed on a surface (at least a rear surface) of the crystalline silicon solar cell 160 in the tandem solar cell 150 according to the present disclosure.

In this case, the crystalline silicon solar cell 160 in the disclosure may be implemented as a hetero-junction silicon solar cell or a homo-junction silicon solar cell.

In the case of a hetero-junction silicon solar cell, a crystalline silicon solar cell may include a crystalline silicon substrate 111 having a texture structure on a second surface, a first surface intrinsic amorphous silicon layer (i-a-Si:H) 112 and a second surface intrinsic amorphous silicon layer (i-a-Si:H) 113 disposed respectively on a first surface and the second surface of the crystalline silicon substrate, a first conductive amorphous silicon layer 114 disposed on the first surface intrinsic amorphous silicon layer 112, and a second conductive amorphous silicon layer 115 disposed on the second surface intrinsic amorphous silicon layer 113.

In this case, the first surface, as illustrated in FIG. 9, which is a front surface of the crystalline silicon substrate, may be a surface where the perovskite layer is formed, and the second surface may be a surface opposite to the first surface, but not limited.

For example, a very thin intrinsic amorphous silicon (i-a-Si:H) layer may be formed on front and rear surfaces of an n-type crystalline silicon substrate as a passivation layer, and a p-type highly concentrated amorphous silicon (p-a-Si:H) layer may be formed on the front surface as an emitter layer 114, and a highly concentrated amorphous silicon (n+ -a-Si:H) layer may be formed on the rear surface as a back surface field (referred to as BSF) layer 115.

For example, a hydrogenated intrinsic amorphous silicon (i-a-Si:H) layer may be used for the intrinsic amorphous silicon layer according to the present disclosure. As hydrogen comes into the amorphous silicon in the hydrogenation reaction, a dangling bond of the amorphous silicon and a localized energy state in an energy band gap may be reduced.

In case the hydrogenated intrinsic amorphous silicon (i-a-Si:H) layer is used, a temperature of the following processing may be limited to 200 °C or lower and, for example, 150 °C or lower. In case the processing temperature is higher than 150 °C, a hydrogen bond in the amorphous silicon may be broken. Accordingly, the following process, particularly, a firing process during a process of forming a metallic grid electrode has to be carried out at a low temperature.

The silicon solar cell 160 according to the disclosure may be implemented as a homo-junction crystalline silicon solar cell. An impurity-doped layer having a different conductivity type from that of the crystalline silicon substrate 111 may be used as the emitter layer 114, and an impurity-doped layer having the same conductivity type as the crystalline silicon substrate 111 may be used as the BSF layer 115. Accordingly, the homo-junction crystalline silicon solar cell 160 may be implemented.

A second electrode including a transparent electrode layer 117 and a grid electrode 118 may be placed on the second surface of the crystalline silicon substrate 111.

In the case of a hetero-junction silicon solar cell, to prevent a hydrogen bond in the amorphous silicon from being broken, a processing temperature of the second electrode (a processing temperature of a busbar electrode 118) may be limited to 150 °C or lower like the processing temperature of the first electrode (a busbar electrode 127). In this case, the second electrode may be formed before the first electrode is formed, or the second electrode and the first electrode may be formed at the same time.

The second electrode may include a transparent electrode layer 117 placed on the BSF layer 115. In case a transparent conductive oxide such as indium tin oxide (ITO), zinc indium tin oxide (ZITO), zinc indium oxide (ZIO), zinc tin oxide (ZTO) and the like is used as a material for the transparent electrode layer, the transparent electrode layer 117 may be deposited through a sputtering process.

The busbar electrode 118 may be disposed on the transparent electrode layer 117. The grid electrode 118 may be directly formed on the BSF layer 115 without forming the transparent electrode layer 117. However, in the case of an amorphous silicon, carrier mobility is not high enough to collect carriers through a metallic grid. Accordingly, the transparent electrode layer 117 is preferable.

The busbar electrode 118 may also be disposed on a finger electrode on the transparent electrode.

In the case of a homo-junction silicon solar cell, the second electrode and the first electrode are not formed at the same time. A high-temperature firing process for forming the second electrode at 700 °C or higher, and a low-temperature firing process for forming the first electrode using first electrode paste including no glass frits at 250 °C or lower may be performed individually.

After the crystalline silicon solar cell 160 is formed as described above, the intermediated layer 116 may be formed on the crystalline silicon solar cell 160, when necessary, and then an ordinary perovskite solar cell 170 may be formed. Accordingly, an ordinary tandem solar cell 150 in the disclosure may be implemented.

The electron transporting layer 123 placed on the intermediate layer 116 may transport electrons, photoelectrically converted in the perovskite layer 124, to another component (e.g., a conductive structure) of the solar cell.

In this case, the electron transporting layer 123 may be formed into an electron conductive organic layer, an electron conductive inorganic layer or a layer including silicon (Si).

The tandem solar cell according to the present disclosure may further include a buffer layer 123' that may help improve electron transport properties between the electron transporting layer 123 and the perovskite layer 124 and that may minimize a defect on an interface, caused due to different materials and different crystalline structures of the electron transporting layer 123 and the perovskite layer 124. Further, even when the electron transporting layer 123 may not perform the function of transporting electrons sufficiently, the buffer layer 123' may solely serve as the electron transporting layer to some degree.

An ordinary tandem solar cell in the disclosure may include a perovskite (absorbing) layer.

The perovskite layer in the disclosure may include methylammonium (MA) or formamidinium (FA). For example, in the perovskite absorbing layer expressed as ABX3 , A may include one or two or more of an alkyl group of +1 of C1-20 , an alkyl group where an amine group is replaced, organic amidinium or alkali metal, B may include one or two or more of Pb2+ , Sn2+ , Cu2+ , Ca2+ , Sr2+ , Cd2+ , Ni2+ , Mn2+ , Fe2+ , Co2+ , Pd2+ , Ge2+ , Yb2+ , Eu2+ , and X may include one or more of F- , Cl- , Br- and I- ·

A band gap of MA (methylamm[[i]]onium) PbI3, which has been so far used as a typical perovskite (absorbing) layer, is known to be about 1.55 to 1.6 eV. An FA-based band gap, which is used as another perovskite absorbing layer, is known to be lower than the MA-based band gap. For example, a band gap of FAPbI3 is about 1.45 eV. However, addition of Br makes a band gap of the FA-based ferovskite absorbing layer similar to a band gap of the existing MA-based perovskite absorbing layer. In case a band gap energy is included in a range of high energies, unlike a silicon solar cell of the related art, a high band gap perovskite layer may absorb light rays of short wavelengths, thereby reducing heat loss caused due to a difference between photon energy and the band gap and generating a high voltage. Thus, efficiency of the solar cell may improve.

A perovskite phase constituting the perovskite layer is highly vulnerable to heat. For the perovskite layer expressed as ABX3 , organic AX and inorganic BX2 are thermally processed and converted into ABX3 . Accordingly, in case organic AX and inorganic BX2 are thermally processed in the conversion process or in a follow-up process at an excessively high temperature for an excessively long period of time, the converted ABX3 may thermally decompose, thereby causing a deterioration of photoelectric conversion efficiency.

In the present disclosure, a hole transporting layer 125 may be additionally formed after the perovskite layer is formed. The hole transporting layer 125 may transport holes, photoelectrically converted in the perovskite layer 124, to another component in the solar cell.

In this case, the hole transporting layer 125 may be formed into a hole conductive organic layer, or a layer including a hole conductive metal oxide or silicon (Si).

When necessary, a front transparent electrode layer 126, and a first electrode including the busbar electrode 129 on the front transparent electrode layer 126 may be disposed again on the hole transporting layer. The busbar electrode 127 may also be disposed on the finger electrode on the transparent electrode.

In this case, the transparent electrode layer 126 may be formed on an entire upper surface of the perovskite solar cell 120 and may collect charges generated in the perovskite solar cell 120. The transparent electrode layer 126 may be made of various transparent conductive materials. That is, materials the same as the transparent conductive materials of the intermediate layer 116 may be used for the transparent electrode layer 116.

In this case, the first electrode (e.g., the busbar electrode 127) may be disposed on the transparent electrode layer 126, and may be disposed in a partial area of the transparent electrode layer 126.

First electrode paste including no glass frits may be optionally applied and then a low-temperature firing process may be performed at a first temperature to manufacture the first electrode (i.e., the busbar electrode 127). The first electrode paste may include metallic particles and organic materials - a binder for low-temperature firing. The first electrode paste may not include glass frits. The first temperature may be 150 °C or lower, and specifically, may be between 100 and 150 °C.

The solar cell, manufactured as described above, may experience the cell test step, the tabbing step, the string step, the lay-up step, the lamination step and the like, which are included in the manufacturing method of a solar cell module of FIG. 8 according to the present disclosure, such that the solar cell module in FIG. 9 is manufactured.

### <Experimental Example>

In the experimental example, a comparison was made between a WVTR of a solar cell module (an embodiment) 200 in FIGS. 4 to 7, to which structures and materials according to the disclosure are applied, and a WVTR of a solar cell module (a comparative example) 100 in FIGS. 2 and 3, to which structures and materials of the related art are applied.

To measure a WVTR in the disclosure, a PERMATRAN-W3/33 system of MOCON Corp. was used as a measuring instrument. Measurement conditions are described as follows. Five module samples having the same size were used respectively for the embodiment and the comparative example. The WVTR of the exemplary example and the comparative example was measured at a temperature of 10 to 40 °C and at a relative humidity (RH) of 35 to 100 %, and was measured with precision of the smallest unit of measurement of about 0.001 g/(m2•day).

The solar cell module 200 according to an aspect of the embodiment had a WVTR from a minimum of 1.41 g/(m2 •day) to a maximum of 1.49 g/(m2 •day), and an average WVTR was about 1.45 g/(m2•day).

The solar cell module 100 according to an aspect of the comparative example had a WVTR from a minimum of 1.89 g/(m2 •day) to a maximum of 221.49 g/(m2•day).

As a result, the solar cell module according to the present disclosure has water vapor transmittance lower than the solar cell module of the related art.

### (Second)

### example useful for understanding the invention but not covered by the scope of the claims

In the present disclosure, a new manufacturing method of a solar cell module may be applied using new materials of a solar cell module including the encapsulating materials in the first embodiment.

According to the above-described method of the related art of an ordinary solar cell module as in FIG. 8, an interconnector and a busbar electrode may be fixed through high-temperature soldering in the tabbing step. However, the solar cell according to the disclosure is vulnerable to heat. Accordingly, the module maturing method of the related art including the high-temperature soldering may not be applied to the solar cell module in the disclosure.

Additionally, in case the interconnector and the busbar electrode are not fixed to each other, it causes failure in the module processing. For example, in case the busbar electrode and the interconnector electrically contact each other and then are laminated in a state where the busbar electrode and the interconnector are not exactly aligned, charge carriers generated in the solar cell may not be efficiently collected, and the misaligned interconnector may not transmit sunlight, thereby causing a reduction in an active surface area of the solar cell. As a result, photoelectric conversion efficiency of the solar cell module may be reduced, and at worst, failure may occur and module yields may be reduced.

In recent years, a linewidth of the busbar electrode as well as the interconnector has been reduced to prevent a reduction in the active surface area of the solar cell, caused due to the interconnector, as much as possible. Accordingly, the busbar electrode and the interconnector need to be aligned accurately.

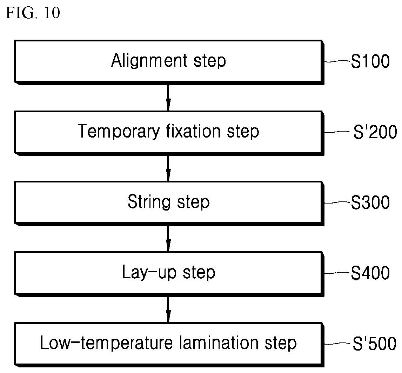

FIG. 10 is a schematic view illustrating a new manufacturing method of a solar cell module according to the present disclosure.

In the manufacturing method of a solar cell module according to the disclosure, a heating process is not included until a lamination step (S' 500), and the lamination step (S' 500) is carried out at a temperature of 150 °C or lower. For example, the manufacturing method of a solar cell module in the disclosure may include a temporary fixation step (S' 200) after a cell test step (S 100), and may include a low-temperature lamination step (S' 500). The low-temperature lamination step (S' 500) is described hereunder.

The temporary fixation step (S' 200) in the disclosure may include temporarily fixing the busbar electrode and the interconnector until the lamination step, without an additional high-temperature processing.

The heating process is not included until the low-temperature lamination step (S' 500) because solar cells in the disclosure have improved photoelectric conversion efficiency unlike crystalline silicon solar cells of the related art having low photoelectric conversion efficiency. The solar cells having improved photoelectric conversion efficiency are described hereunder.

A perovskite solar cell including organic and inorganic perovskite absorbing layers or a tandem solar cell including a perovskite solar cell in the present disclosure, and a highly efficient HIT (hetero-junction with intrinsic thin film) solar cell among crystalline silicon solar cells of the related art requires a low-temperature processing.

The perovskite absorbing layer is very vulnerable to heat and moisture and is decomposed by heat in a high-temperature manufacturing process performed at a temperature of 200 °C or higher.

There may be a defect or a silicon dangling bond in an amorphous silicon buffer layer in the HIT silicon solar cell. To solve the problems, an intrinsic amorphous silicon buffer layer (i-a-Si:H), where hydrogen is added as a dopant, may be used. In case a high-temperature processing performed at 200 °C or higher is included in the following steps, the hydrogen in the doped buffer layer may escape from the buffer layer by diffusion. Accordingly, the HIT silicon solar cell or the tandem solar cell including the HIT silicon solar cell also requires a low-temperature processing.

Further, in a manufacturing method by which a module is manufactured using the highly efficient solar cell, a high-temperature processing performed at 150 °C or higher needs to be excluded.

The temporary fixation of the busbar electrode and the interconnector in the disclosure may be implemented through various processes.

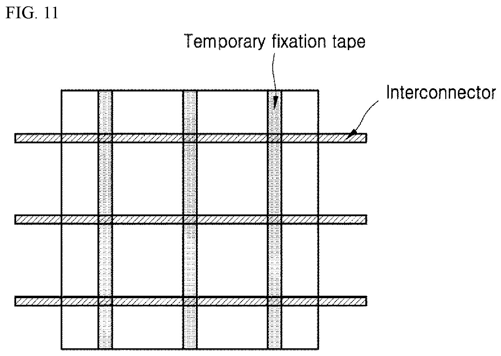

FIG. 11 illustrates a state where interconnectors aligned with respect to busbar electrodes are temporarily fixed using a temporary fixation tape in an aspect of the temporary fixation step according to the disclosure.

In the present disclosure, interconnectors are aligned on busbar electrodes and the interconnectors on the busbar electrodes are temporality fixed using a temporary fixation tape. The term "temporary fixation" is used instead of the term "fixation" because the term "fixation" is used when the busbar electrodes and the interconnectors are completely fixed mechanically and/or electrically through a soldering processing in the following lamination step.

For example, the temporary fixation tape according to the disclosure may temporarily fix the interconnectors in a direction across a length-wise direction of the interconnectors.

In case the temporary fixation tape temporarily fixes the interconnectors in the length-wise direction of the interconnectors, a fraction of the temporary fixation tape on the surface of the solar cell becomes too large. In case the surface area taken up by the temporary fixation tape becomes too large, a surface area of a surface of the solar cell, where sunlight is absorbed, may be reduced. Thus, photoelectric conversion efficiency of the solar cell module may be deteriorated.

When the temporary fixation tape temporarily fixes the interconnectors in the direction across the length-wise direction of the interconnectors, a plurality of interconnectors may be fixed at a time, thereby ensuring a shorter lead time and improvement in productivity.

The temporary fixation tape in the disclosure may be made of a material that may excellently transmit sunlight. Further, the temporary fixation tape may have excellent resistance against heat and excellent adhesion as the temporary fixation tape has to stably fix the interconnectors in their positions even in the following lamination step (S' 500).

As a non-limited example, polyethylene (PE), polypropylene (PP), polyethylene terephthalate (PET), polyvinyl chloride (PVC) and the like may be used as a base of the tape. Additionally, acrylic resin, cellulose-based resin or silicon-based resin may be used as an adhesive to manufacture a temporary fixation tape having transparency, insulation and adhesion.

In FIG. 11, three busbar electrodes are disposed on a single solar cell as an example but not limited. In principle, one or more busbar electrodes may be disposed on a single solar cell. Additionally, interconnectors as many as busbar electrodes may be disposed on a single solar cell.

Referring back to FIG. 11, the plurality of interconnectors 142 may be spaced a predetermined distance apart from each other not only in the solar cell module but also in each solar cell constituting the module. As a non-limited example, the number of interconnectors 142 in a single cell may be 1 to 38.

The interconnector may have mechanical measurements. A width of the interconnector in combination with the number and shape of the interconnectors may affect absorption and reflection of sunlight in the below described solar cell module as well as adhesion to the busbar electrode.

In case the number of interconnectors in a single cell is 1 to 5, a width (W1) of the interconnector may be 0.5 to 1.5 mm. In case the number of interconnectors in a single cell is 6 or more, a width of the interconnector may be 250 to 500 um.

In case the width (W1) of the interconnector 142 is less than 250 um, the interconnector 142 may not ensure sufficient strength, and a surface area, where the interconnector 142 connects with the busbar electrode, may be too small. Thus, an electric connection and adhesion may be deteriorated. In case the width (W1) of the interconnector 142 is more than 500 um, costs incurred for the interconnectors 142 may increase, and the interconnectors 142 may interfere with incidence of light rays incident on the front surface of the solar cell 150, causing an increase in light loss. Additionally, as a force, which is applied at the interconnectors 142 in a direction where the interconnectors 142 are spaced apart from the busbar electrodes, becomes greater, adhesion between the interconnectors 142 and the busbar electrodes may become lower, and there may be a problem including a crack and the like with the busbar electrodes or a semiconductor substrate 150.

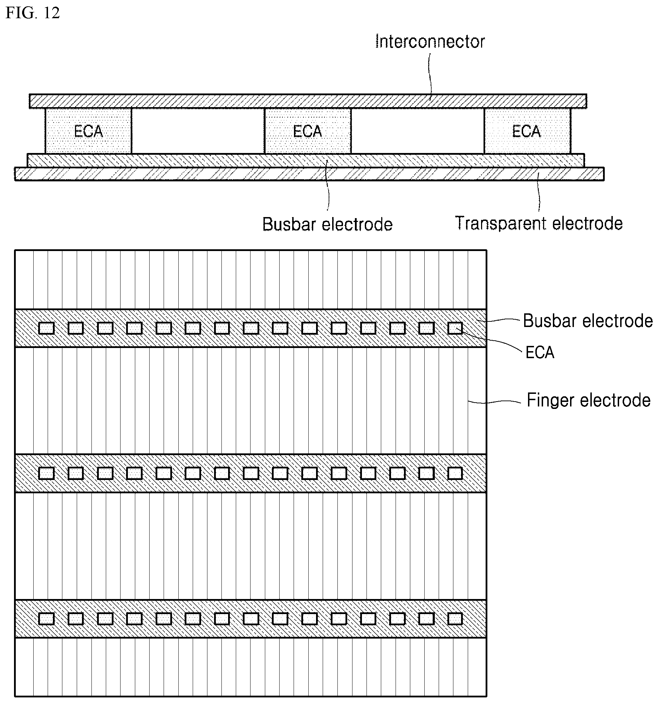

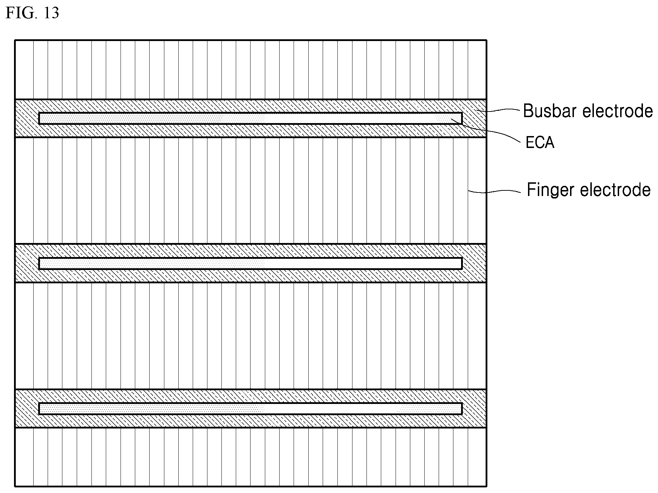

FIGS. 12 and 13 are views illustrating a state where aligned interconnectors are temporarily fixed using an electro-conductive adhesive according to an aspect of an embodiment. FIG. 12 (a) and FIG. 12 (b) illustrate an electro-conductive adhesive applied discontinuously, and FIG. 13 (a) and FIG. 13 (b) illustrate an electro-conductive adhesive applied continuously.

Though not illustrated, an interconnector 142 is disposed on the electro-conductive adhesive. Accordingly, a width of the interconnector may be narrower than a width of a busbar electrode.

As illustrated in FIGS. 12 and 13, in the temporary fixation step according to the disclosure, an electro-conductive adhesive (ECA) may be disposed between each of the busbar electrodes and each of the interconnectors to temporarily fix the busbar electrodes and the interconnectors.

The electro-conductive adhesive may be a mixture where micro-sized, mezzo-sized or nano-sized metallic particles are dispersed in a sticky polymer such as epoxy-based, polyurethane-based, silicon-based, polyimide-based, phenol-based, polyester-based ones and the like. In this case, the metallic particles may include silver, copper, aluminum, tin or alloys thereof.

The electro-conductive adhesive according to the disclosure may be disposed in a length-wise direction of the busbar electrode and the interconnector. The electro-conductive adhesive generally has low light transmittance due to materials constituting the adhesive. Accordingly, when the electro-conductive adhesive is disposed only between the interconnectors and the busbar electrodes, a reduction in the active surface area of the solar cell, caused due to the adhesive, may be prevented.

The electro-conductive adhesive in the disclosure may be applied on the busbar electrodes and then may temporarily fix the busbar electrodes and the interconnectors while aligning the interconnectors. Alternatively, the electro-conductive adhesive may be applied or coated onto one surface of the interconnectors and then may temporarily fix the busbar electrodes and the interconnectors at the same time while aligning the interconnectors.

In FIGS. 12 and 13, the busbar electrode is disposed to cross the finger electrodes formed on the transparent electrode but not limited. According to the present disclosure, a plurality of busbar electrodes may be disposed on a single solar cell without any finger electrode, and the interconnector may be in a direction across the finger electrodes without an additional busbar electrode.

The solar cells including the interconnector temporarily fixed to the busbar electrode may experience a string step (S300), a lay-up step (S400) and a lamination step (S'500).

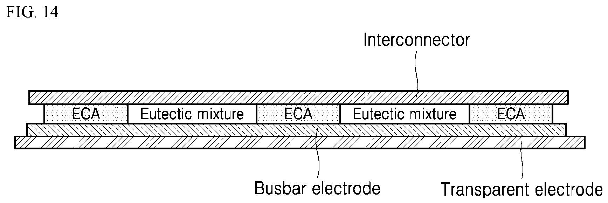

FIG. 14 is a view illustrating a state where the busbar electrode and the interconnector connect, after the interconnectors, temporarily fixed using an electro-conductive adhesive according to the present disclosure, is laminated (S' 500).

As illustrated in FIG. 14, the interconnector, temporarily fixed to the busbar electrode, may be coupled or fixed to the busbar electrode electrically and/or mechanically after the low-temperature lamination step (S' 500) where heat and pressure are applied.

In this case, an interface between the busbar electrode and the interconnector before the lamination step (S'500) definitely differs from the interface after the lamination step (S' 500).

As illustrated in FIG. 12, there may be an electro-conductive adhesive or in some cases, a vacant space, at the interface between the busbar electrode and the interconnector, before the lamination step and after the temporary fixation step.

In FIG. 12, the electro-conductive adhesive is discontinuously disposed in the length-wise direction of the interconnector (the same as the length-wise direction of the busbar) but not limited. As in FIG. 13, the electro-conductive adhesive may be continuously disposed or applied in the length-wise direction of the interconnector. In this case, from a perspective of electric conductivity, an amount or a thickness and the like of the applied electro-conductive adhesive may be adjusted to extract charge carries from the cell.

In case the electro-conductive adhesive is discontinuously disposed in the length-wise direction of the interconnector, a length to which the electro-conductive adhesive layer is disposed may account for 1 to 25% of an entire length of the interconnector. In case the length of the electro-conductive adhesive layer accounts for less than 1 % of the length of the interconnector, adhesion between the busbar electrode and the interconnector is too low, and the interconnector temporarily fixed to the busbar electrode may come off. In case the length of the electro-conductive adhesive layer accounts for more than 25 % of the length of the interconnector, a thickness and the like of the adhesive layer has to be adjusted. Unless the thickness and the like of the adhesive layer is adjusted, electric conductivity between the busbar electrode and the interconnector may become low, and due to lower efficiency of extracting charge carriers, photoelectric conversion efficiency of the solar cell module may be deteriorated.

After the lamination step (S'500) where heat and pressure are applied, a eutectic mixture including an inter-metallic compound, which would otherwise be absent before the lamination step, in addition to the electro-conductive adhesive, may be newly formed between the busbar electrode and the interface, as illustrated in FIG. 14.

According to the present disclosure, the inter-metallic compound may be formed at the interface for the following reasons.

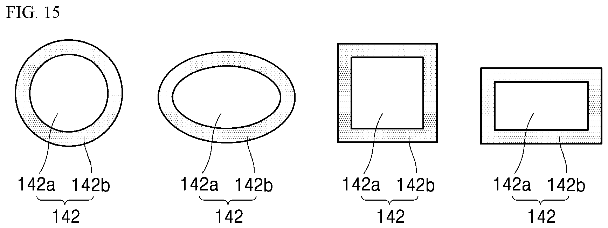

As illustrated in FIG. 15, for the interconnector used for the solar cell, an alloy 142b, where tin (Sn), silver (Ag), lead (Pb) and the like are mixed, is coated and manufactured on a surface of a copper base 142a through various processes such as a plating process, a dipping process and the like, to electrically connect the solar cells .

As a non-limited example, a coating material including tin (Sn) may be made of Sn, SnIn, SnBi, SnBiPb, SnPb, SnPbAg, SnCuAg, SnCu and the like.

Additionally, antimonial lead where about 1 to 10 wt.% of antimony (Sb) is included in lead (Pb), or hard lead, among materials including lead (Pb), may be widely used as a coating material of a cable like the interconnector.

The interconnector including the above ingredients may be laminated by applying heat and pressure at 150 °C or lower in the low-temperature lamination step (S'500).

A processing temperature in the low-temperature lamination step (S'500) according to the disclosure is limited to a maximum of 150 °Cfor the following reasons.

As described above, the solar cell according to the disclosure may be a highly efficient solar cell such as a perovskite solar cell or a hetero-junction solar cell using amorphous silicon.

In terms of the highly efficient solar cell according to the disclosure, particularly, the perovskite solar cell, reports suggest that decomposition of perovskite materials may be accelerated due to moisture and thermal instability.

The perovskite materials are very vulnerable to high temperatures, and even in a vacuum state, an absorbing layer made of CH3 NH3 PbI3 is decomposed at 150°C or higher and degradation of a cell may occur after three hours passes. When the perovskite materials are exposed at 85°C for 24 hours, the perovskite materials may remain stable in a vacuum atmosphere or in a nitrogen (N2) atmosphere and in an oxygen (O2) atmosphere. Accordingly, the perovskite solar cell according to the disclosure is very vulnerable to heat and requires a low-temperature lamination processing (S' 500) performed at 150°C or lower.

In the busbar electrode and the temporarily fixed interconnector according to the disclosure, silver (Ag), which is a main ingredient of the busbar electrode, may react with tin (Sn) or antimony (Sb), which is an ingredient of an alloy of the coating layer 142b of the interconnector, in the low-temperature lamination step (S'500). As the alloy of the coating layer 142b of the interconnector is generally melted at 150 °C or lower, the alloy may be melted in the lamination step and may react with silver (Ag) of the busbar electrode.

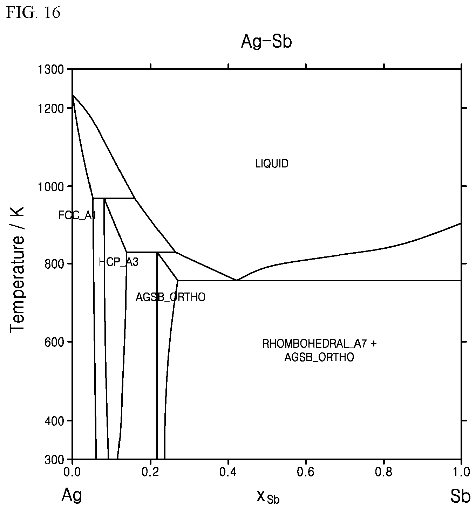

Silver (Ag) and lead (Pb) do not form an inter-metallic compound. However, as illustrated in the view of an Ag-Sb state of FIG. 16, silver (Ag) and antimony (Sb) include an inter-metallic compound having a crystalline structure of an orthorhombic system in a composition area.

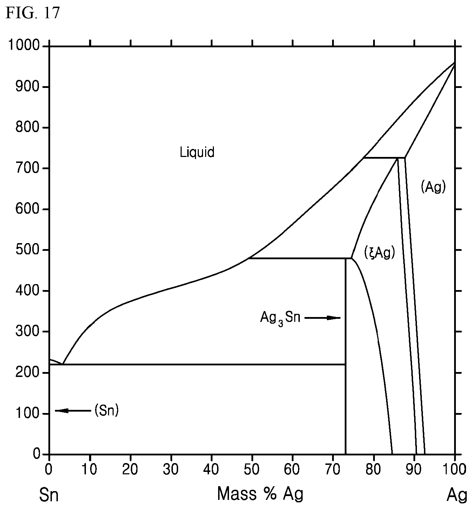

As illustrated in the view of an Ag-Sn state of FIG. 17, Ag and Sn alloy systems may also include an inter-metallic compound composed of Ag3 Sn in the composition area.

Accordingly, in the low-temperature lamination step (S'500) according to the disclosure, the Ag-Sb or Ag-Sn inter-metallic compound may be included between the interconnector and the busbar electrode, and a eutectic mixture, where the Ag-Sb or Ag-Sn inter-metallic compound is mixed with Sb or Sn - a main ingredient of the interconnector and the busbar electrode, may be formed between the interconnector and the busbar electrode. The eutectic mixture in the disclosure may have higher adhesion and electric conductivity than an adhesive.

As a result, an embodiment (FIG. 12) according to the disclosure, where the electro-conductive adhesive is discontinuously disposed in the length-wise direction of the interconnector and temporarily fixes the busbar electrode and the interconnector, may have an interface structure ( FIG. 14) in which the electro-conductive adhesive and the eutectic mixture are alternately disposed between the busbar electrode and the interconnector through the lamination process (S' 500).

After the lamination step (S'500), a ratio of the surface areas of the electro-conductive adhesive layer and the eutectic mixture (or a ratio of the lengths of the electro-conductive adhesive layer and the eutectic mixture in the length-wise direction of the interconnector), in the interface layer, may be 1~25: 75~99, for example.

In case the ratio of the electro-conductive adhesive layer is less than 1 % (or the ratio of the eutectic mixture is more than 99 %), adhesion between the busbar electrode and the interconnector may not be ensured in the temporary fixation step, causing failure in the temporary fixation. In case the ratio of the electro-conductive adhesive layer is more than 25 % (or the ratio of the eutectic mixture is less than 75 %), a high electric conductivity between the busbar electrode and the interconnector may not be ensured after the lamination step, causing a problem with the collection of charge carriers.

Referring back to FIG. 15, the interconnector according to the disclosure may have various shapes. For example, the interconnector may have a circle-shape cross section, an oval-shaped cross section, or a polygon-shaped cross section.

A circle-shaped interconnector or an oval-shaped interconnector may have a small surface area, where the circle-shaped interconnector or the oval-shaped interconnector contacts the busbar electrode, unlike a polygon-shaped interconnector. Thus, in the temporary fixation step, due to its surface area or length, the temporary fixation tape or the electro-conductive adhesive layer accounts for a larger portion of the interface. However, the circle-shaped interconnector or the oval-shaped interconnector may cause scattering or refraction of sunlight and lengthen an optical path, thereby enabling an increase in absorption efficiency of sunlight.

On the contrary, a polygon-shaped interconnector (e.g., a rectangle-shaped interconnector) may have a maximized surface area, where the polygon-shaped interconnector contacts the busbar electrode. Accordingly, a fraction of the temporary fixation tape or the electro-conductive adhesive layer on the interface may be minimized. However, due to its shape, the polygon-shaped interconnector may reflect incident sunlight to the solar cell below the connector, without scattering or refracting a part of the sunlight, causing a reduction in absorption efficiency of sunlight.

The new manufacturing method of a solar cell module in the second embodiment along with the new materials for a solar cell module in the first embodiment may be applied to a new solar cell for a solar cell module and a manufacturing method thereof in a below-described third embodiment.

### <Third Embodiment>

The new materials of a solar cell module including the encapsulating materials in the first embodiment, and the solar cell applied to the new manufacturing method of a solar cell module in the second embodiment may be used for a solar cell and a manufacturing method thereof in the below-described third embodiment.

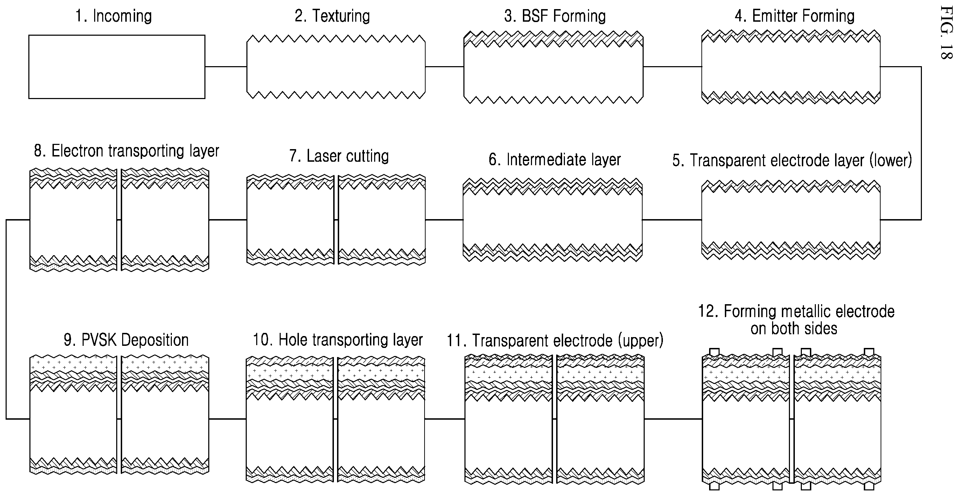

FIG. 18 is a view illustrating an embodiment, where a solar cell constituting a tandem solar cell module including a perovskite absorbing layer according to the present disclosure, is formed.

The tandem solar cell according to the disclosure may include a lower solar cell and an upper solar cell. In this case, the lower solar cell may have a lower band gap than the upper solar cell. FIG. 18 illustrates a crystalline silicon solar cell as the lower solar cell in the tandem solar cell. However, it is sufficient that the lower solar cell according to the disclosure has a lower bad gap than the upper solar cell. Accordingly, the lower solar cell may not be limited to a crystalline silicon solar cell.

As illustrated in FIG. 18, a crystalline silicon substrate as a start material may be textured.

A crystalline silicon solar cell in the tandem solar cell according to the disclosure may have irregularities on a first surface and/or a second surface of the silicon substrate through a texturing process to prevent reflection. For example, the irregularities may include specific crystalline surfaces. The irregularities may have an approximate pyramid shape formed by four surfaces that are a surface {111}. Silicon, which has a crystalline structure of a diamond cubic, may have a face-centered cubic (FCC) lattice. In case the lattice has a face-centered cubic structure, the surface {111} may be a dense surface and the most stable surface.

When the irregularities are formed on the surface of the substrate through the texturing process, light incident to the semiconductor substrate may be prevented from reflecting, thereby effectively reducing light loss.

Then a first or second conductive dopant, which is a base dopant, may be doped on the crystalline silicon substrate at low doping concentrations to implement a first or second conductive crystalline semiconductor. For example, the substrate may include a monocrystalline semiconductor or a polycrystalline semiconductor (e.g., a monocrystalline silicon or a polycrystalline silicon.

In this case, the crystalline silicon solar cell 110 illustrated as the lower solar cell in the disclosure may be implemented as a hetero-junction silicon solar cell or a homo-junction silicon solar cell.

As illustrated in FIG. 18, the silicon solar cell according to the present disclosure may be implemented as a homo-junction crystalline silicon solar cell. In the homo-junction crystalline silicon solar cell having a front emitter layer and a back surface field layer, an impurity doped layer having a different conductivity type from the crystalline silicon substrate may be used as the emitter layer, and an impurity doped layer having the same conductivity type as the crystalline silicon substrate may be used as the back surface filed layer, to implement the homo-junction crystalline silicon solar cell.

In FIG. 18, the back surface field layer may be formed and then the front emitter layer may be formed, but not limited. Alternatively, according to the disclosure, the front emitter layer may be formed and then the back surface filed layer may be formed.

Additionally, the silicon solar cell according to the present disclosure may also be implemented as a hetero-junction crystalline silicon solar cell.

In the hetero-junction silicon solar cell, the crystalline silicon solar cell may include a crystalline silicon substrate, a first surface and/or a second surface of which is textured; a first passivation layer and a second passivation layer disposed respectively on the first surface and the second surface of the crystalline silicon substrate; a first conductivity-type area disposed on the first passivation layer; and a second conductivity-type area disposed on the second passivation layer. In this case, the first conductivity-type area may be the back surface field layer or the emitter layer, and the second conductivity-type area may have an opposite type of conductivity from the first conductivity-type area and may be the emitter layer or the back surface filed layer.

Then an intermediate layer (or a tunnel junction layer) may be disposed (e.g., contact) on the emitter layer, and a lower electrode electrically connected to the back surface field layer may be disposed (e.g., contact) on the back surface field layer.

In FIG. 18, the emitter layer is disposed along with the intermediate layer, but not limited. As described above, the back surface field (BSF) layer may be disposed along with the intermediate layer.

The lower electrode may further include a lower-electrode transparent electrode layer disposed between the back surface filed layer and a metallic electrode layer of the lower electrode.

The lower-electrode transparent electrode layer may be formed (e.g., contact) entirely on the back surface field layer. Being entirely formed may denote not only covering the back surface filed layer entirely with no vacant space or with no vacant area but also including a part where the lower-electrode transparent electrode layer is not formed inevitably.

When the lower-electrode transparent electrode layer is formed entirely on the back surface filed layer, carries may easily reach the metallic electrode layer of the lower electrode through the lower-electrode transparent electrode layer, thereby reducing resistance in a horizontal direction.

In case the back surface field layer is made of amorphous silicon and the like, crystallinity of the back surface filed layer may be relatively low, causing lower mobility of carriers. Accordingly, resistance, which occurs when the carriers move horizontally, may be reduced with the lower-electrode transparent electrode layer.

Then a lower-electrode metallic electrode may be disposed on the lower-electrode transparent electrode layer. The lower-electrode metallic electrode layer may be formed after the lower solar cell is manufactured, or may be formed along with an upper-electrode metallic electrode layer after the upper solar cell is manufactured (see FIG. 18).

In this case, the lower-electrode metallic electrode layer may include metal and crosslink resin. The lower-electrode metallic electrode layer may include metal to improve carrier collection efficiency and to ensure a reduction in resistance and the like. As the lower-electrode metallic electrode layer includes metal, the lower-electrode metallic electrode layer may interfere with incidence of light. Accordingly, the lower-electrode metallic electrode layer may have a predetermined pattern to minimize shading loss. By doing so, light may be incident to a portion where the lower-electrode metallic electrode layer is not formed.

Then the intermediate layer may be disposed on the emitter layer.

The intermediate layer in the tandem solar cell according to the disclosure may be made of a transparent conductive oxide, a carbonaceous conductive material or a metallic material such that long-wavelength light rays passing through the upper solar cell are incident to the lower solar cell without light loss.

For example, the transparent conductive oxide may include indium tin oxide (ITO), indium tungsten oxide (IWO), zinc indium tin oxide (ZITO), zinc indium oxide (ZIO), zinc tin oxide (ZTO), gallium indium tin oxide (GITO), gallium indium oxide (GIO), gallium zinc oxide (GZO), aluminum doped zinc oxide (AZO), fluorine tin oxide (FTO) or ZnO and the like.

The upper solar cell may be disposed on the intermediate layer according to the disclosure.

In case the upper solar cell according to the disclosure is a perovskite solar cell, the upper solar cell may include a second conductivity-type charge transporting layer (or a transporting layer) disposed on the lower solar cell; a perovskite absorbing layer disposed on the second conductivity-type charge transporting layer; a first conductivity-type charge transporting layer (or a transporting layer) disposed on the perovskite absorbing layer 132; and an upper electrode layer disposed on the first conductivity-type charge transporting layer.

As a non-limited example, in case the crystalline silicon substrate is an n-type monocrystalline silicon substrate, the first conductivity-type area may serve as an emitter layer of a p-type highly concentrated amorphous silicon (p+-a-Si:H) layer different from the substrate, and the second conductivity-type area may serve as a back surface field (referred to as "BSF") layer of an n-type highly concentrated amorphous silicon (n+ -a-Si:H) layer.

In this case, like the second conductivity-type area, the second conductivity-type charge transporting layer in the upper solar cell may be a n-type charge transporting layer, and like the first conductivity-type area 114, the first conductivity-type charge transporting layer on the perovskite absorbing layer 132 may be a p-type charge transporting layer 133. The upper solar cell disposed as described above may be a perovskite solar cell, particularly, a perovskite solar cell having an ordinary laminated structure.

In the upper solar cell according to the disclosure different from the above lower solar cell, the substrate may be divided prior to any one of unit processes of forming the first to second conductivity-type charge transporting layers (or transporting layers) of the upper solar cell, and then the upper solar cell may be manufactured.

As a substrate used for the tandem solar cell according to the disclosure is a crystalline silicon substrate, the scribing process widely used in the semiconductor area may be adopted to divide the substrate, in the disclosure.

In general, the scribing process may denote a process where grooves are formed on surfaces of wafers using a diamond cutter, a laser and the like such that the wafers are cut into a plurality of chips.

In this specification, as a way of improving photoelectric conversion efficiency of the solar cell, a standardized solar cell, i.e., a single solar cell using a pseudo square-type semiconductor substrate may be divided into a plurality of pieces through the scribing process to manufacture a small solar cell (referred to as "mini-cell". Then the mini-cells may be collected and electrically connected directly or indirectly with each other to manufacture a solar cell module according to the present disclosure.

As illustrated in FIG. 18, for the upper solar cell according to the disclosure, the substrate may be divided and then an electron transporting layer may be formed. Accordingly, a process in the following embodiment may be performed not on a mother substrate but on each of the divided unit substrates (i.e., mini-cells).

The electron transporting layer according to the disclosure may be formed into an electron conductive organic layer, an electron conductive inorganic layer or a layer including silicon (Si).

The electron conductive organic material may be an organic material used as an n-type semiconductor in an ordinary solar cell. As a non-limited specific example, the electron conductive organic material may include fullerene (C60 , C70 , C74 , C76 , C78 , C82 , C95), PCBM([6,6]-phenyl-C61butyric acid methyl ester)) and fulleren-derivatives including C71-PCBM, C84-PCBM, PC70BM([6,6]-phenyl C70-butyric acid methyl ester), PBI(polybenzimidazole), PTCBI(3,4,9,10-perylenetetracarboxylic bisbenzimidazole), F4-TCNQ(tetra uorotetracyanoquinodimethane) or combinations thereof.

The electron conductive inorganic material may be a metal oxide commonly used to transport electrons in an ordinary quantum dot-based solar cell or dye-sensitized solar cell. As a non-limited specific example, the metal oxide may include one or two or more selected from Ti oxide, Zn oxide, In oxide, Sn oxide, W oxide, Nb oxide, Mo oxide, Mg oxide, Ba oxide, Zr oxide, Sr oxide, Yr oxide, La oxide, V oxide, Al oxide, Y oxide, Sc oxide, Sm oxide, Ga oxide, In oxide and SrTi oxide, and may include mixtures thereof or composites thereof.

The electron transporting layer, which is a layer including silicon (Si), may be made of a material including one or two or more of amorphous silicon (n-a-Si), amorphous silicon oxide (n-a-SiO), amorphous silicon nitride (n-a-SiN), amorphous silicon carbide (n-a-SiC), amorphous silicon oxynitride (n-a-SiON), amorphous silicon carbonitride (n-a-SiCN), amorphous silicon germanium (n-a-SiGe), microcrystalline silicon (n-uc-Si), microcrystalline silicon oxide (n-uc-SiO), microcrystalline silicon carbide (n-uc-SiC), microcrystalline silicon nitride (n-uc-SiN) and microcrystalline silicon germanium (n-uc-SiGe).

Then a perovskite absorbing layer may be disposed on the electron transporting layer.

The widely-used methylammonium (MA)-based perovskite compound, or a formamidinium (FA)-based perovskite compound may be used for the perovskite absorbing layer in the present disclosure.

Considering band gap properties, as MAPbI3, which is a typical MA-based perovskite compound, has a higher band gap than [[M]]FAPbI3 which is a typical FA-based perovskite compound. A band gap of MAPbI3 is about 1.55 to1.6 eV, and a band gap of FAPbI3 is about 1.45 eV. Accordingly, MAPbI3 has an advantage over FAPbI3 in absorbing short-wavelength light rays.

The FA-based perovskite compound has a unique feature of high-temperature stability. Accordingly, the FA-based perovskite compound is more stable at high temperatures than the MA-based perovskite compound. Further, it has turned out that when the FA-based perovskite compound is doped with Br, the band gap of the perovskite compound increases. Additionally, it has been revealed that when Cs is added to the FA-based perovskite compound, production of an unwanted delta (δ) phase FA-based compound may be suppressed.

For example, in the present disclosure, FA1-x Csx PbBry I3-y may be used for the perovskite absorbing layer made of an FA ingredient (In this case, conditions of 0 ≤ x ≤ 1 and 0 ≤ y ≤ 3 needs to be satisfied.).

The addition of Br may make a band gap of the FA-based perovskite absorbing layer similar to a band gap of the existing MA-based perovskite absorbing layer. When band gap energy increases to a range of high energies, unlike a silicon solar cell of the related art, a high band gap perovskite layer may absorb light rays of short wavelengths, thereby reducing heat loss caused due to a difference between photon energy and the band gap and generating a high voltage. Thus, efficiency of the solar cell may improve.

A hole transporting layer may be disposed on the perovskite absorbing layer.

A hole transporting layer applicable in the disclosure may be formed into a layer including a hole conductive organic layer, or a layer including a hole conductive metal oxide or silicon (Si).

The hole conductive organic material may be an organic hole transporting material commonly used to transport holes in an ordinary dye-sensitized solar cell or an organic solar cell. As a non-limited specific example, the electron conductive organic material may include one or two or more selected from polyaniline, polypyrrole, polythiophene, poly-3,4-ethylenedioxythiophene-polystyrene sulfonate (PEDOT-PSS), poly-[bis(4-phenyl)(2,4,6-trimethylphenyl)amine](PTAA), polyaniline-camphorsulfonic acid (PANI-CSA), pentacene, coumarin 6(coumarin 6,3-(2-benzothiazolyl)-7-(diethylamino)coumarin), ZnPC(zinc phthalocyanine), CuPC(copper phthalocyanine), TiOPC(titanium oxide phthalocyanine), Spiro-MeOTAD(2,2',7,7'-tetrakis(N,N-p-dimethoxyphenylamino)-9,9'-spirobifluorene),F16CuPC(copper(II)1,2,3,4,8,9,10,11,15,16,17,18,22,23,24,25-hexadecafluoro-29H,31H-phthalocyanine), SubPc(boron subphthalocyanine chloride) and N3(cis-di(thiocyanato)-bis(2,2'- bipyridyl-4,4'-dicarboxylic acid)-ruthenium(II)).

The metal oxide may include Ni oxide, Mo oxide, V oxide and the like. In this case, when necessary, the hole transporting layer may further include an n-type dopant or a p-type dopant.

According to the present disclosure, the hole transporting layer including silicon (Si), for example, may be made of a material including one or two or more of amorphous silicon (p-a-Si), amorphous silicon oxide (p-a-SiO), amorphous silicon nitride (pa-SiN), amorphous silicon carbide (p-a-SiC), amorphous silicon oxynitride(p-a-SiON), amorphous silicon carbonatride (p-a-SiCN), amorphous silicon germanium (p-a-SiGe), microcrystalline silicon (p-uc-Si), microcrystalline silicon oxide (p-uc-SiO), microcrystalline silicon carbide (p-uc-SiC), microcrystalline silicon nitride (p-uc-SiN) and microcrystalline silicon germanium (p-uc-SiGe).

Then an upper electrode may be disposed on the hole transporting layer according to the present disclosure.

The upper electrode may include an upper-electrode transparent electrode layer. The upper-electrode transparent electrode layer may be formed entirely on an upper surface of the perovskite solar cell and may collect charges generated in the peroveskite solar cell.

The upper-electrode transparent electrode layer may be made of various transparent conductive materials. The transparent conductive oxide used for the transparent electrode layers of the upper electrode or the lower electrode may include indium tin oxide (ITO), indium tungsten oxide (IWO), zinc indium tin oxide (ZITO), zinc indium oxide (ZIO), zinc tin oxide (ZTO), gallium indium tin oxide (GITO), gallium indium oxide (GIO), gallium zinc oxide (GZO), aluminum doped zinc oxide (AZO), fluorine tin oxide (FTO) or ZnO and the like.

Then an upper-electrode metallic electrode layer may be disposed on the upper-electrode transparent electrode layer and may be disposed in a partial area of the upper-electrode transparent electrode. Further, as illustrated in FIG. 18, a lower-electrode metallic electrode layer and the upper-electrode metallic electrode layer may be formed at the same time.

To manufacture the upper-electrode metallic electrode layer, paste including no glass frits may be optionally applied and then a low-temperature firing process may be performed. The electrode paste for the upper-electrode metallic electrode layer may include metallic particles, and organic materials that a binder for the low-temperature firing process. The electrode paste for the upper electrode may not include glass frits. For example, a processing temperature of the upper-electrode metallic electrode may be 250 °C or lower, specifically, 100 to 200. This is because the tandem solar cell according to the disclosure includes a perovskite absorbing layer that is very vulnerable to heat and is decomposed or damaged in a heating process.

In the third embodiment, the manufacturing method of the tandem solar cell and module according to an aspect of the embodiment may ensure a unit layer of the same quality as that of the related art, while ensuring significant improvement in productivity.

The unit layers of the electrode transporting layer, the perovskite absorbing layer and the hole transporting layer, constituting the perovskite solar cell, may be formed on the textured crystalline silicon solar cell while experiencing conformal growth or having coating features. This is because a thickness of the unit layers is much smaller than a height of the texture of the substrate or lower layers and because the unit layers are generally formed in a solution processing and the like.

However, in the tandem solar cell and module according to the disclosure, as the crystalline silicon substrate as a mother substrate may be used up to the unit layer of the lower solar cell, the tandem solar cell and module may ensure improved productivity unlike a solar cell and module manufactured on a processing process of the related art where mini-cells are used. Additionally, from a processing of the unit layer of the perovskite solar cell that is an upper solar call, the substrate is divided into mini-cells and the unit layer is formed from a desired step through a scribing process, thereby ensuring uniformity of the unit layer.

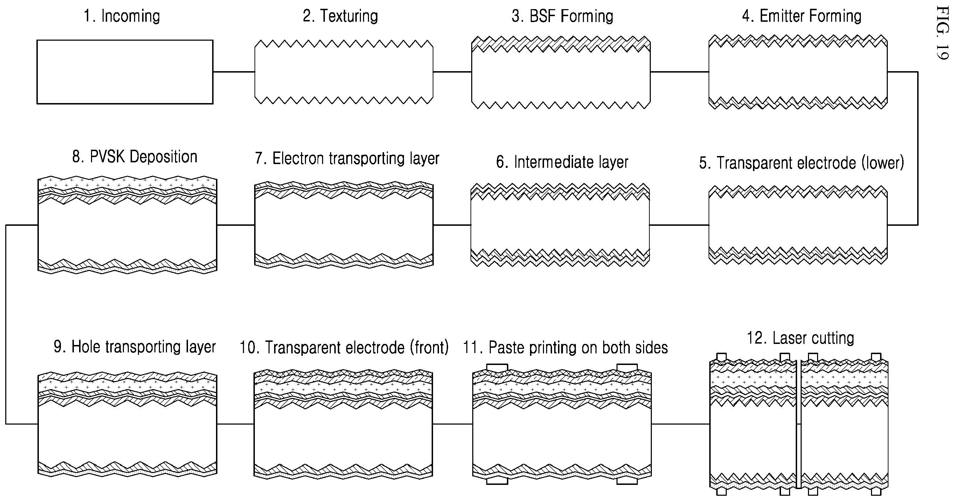

FIG. 19 is a view illustrating another embodiment where a solar cell, constituting the tandem solar cell module including a perovskite absorbing layer in the third embodiment, is formed.

FIG. 19 differs from FIG. 18, depending on a step where a scribing process is applied.

In the embodiment of FIG. 18, the scribing process may be performed between unit layer processes of a perovskite solar cell that is a first solar cell. In the embodiment of FIG. 19 , the scribing process may be performed after the tandem solar cell including the first solar cell is entirely formed.

Thus, the embodiment in FIG. 19 as another embodiment has an advantage over the embodiment in FIG. 18 in that productivity of a tandem solar cell and module may improve. However, the unit layers of the tandem solar cell (e.g., a perovskite solar cell) in the embodiment of FIG. 19 may have lower uniformity than that of the related art or the embodiment in FIG. 18.

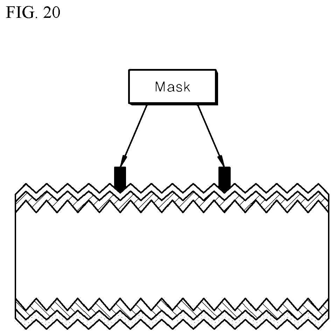

According to the present disclosure, as illustrated in FIG. 20, masks may be formed at boundaries of mini-cells for forming a module in a mother substrate to ensure uniformity of unit layers constituting the perovskite solar cell in another embodiment, before the perovskite solar cell at an upper portion of the tandem solar cell is formed.

When necessary, the step of forming a mask may be added among the manufacturing processes in the embodiment of FIG. 19 - from the step of depositing the intermediate layer to the step of depositing the hole transporting layer. As described with reference to the embodiment in FIG. 18, in the processing for each unit layer constituting the perovskite solar cell, solution processes may be generally applied, and when necessary, a thin film process may be applied. Thus, like the scribing process, the step of forming a mask according to the disclosure may be performed before a process where a unit layer, which is the hardest to ensure uniformity among the unit layers, is formed, thereby ensuring productivity as well as uniformity.

In the process of forming mask in another embodiment, the number of processes and lead time may be significantly reduced unlike the scribing process.

For example, there is a big difference between a process, where n-numbered mini-cells are formed in a single mother substrate through the scribing process and then n-numbered unit processes are performed in each of the mini-cells, and a process where n-numbered mini-cells are divided in a mother substrate through a mask and then n-numbered unit processes are performed, in relation to the lead time.

In case n-numbered mini-cells are formed through the scribing process and then a single unit layer process is performed, a substrate may need n-numbered transport and alignment processes. Additionally, in case the unit process is a thin film process, additional equipment or time for maintaining a vacuum sate may be needed.

However, in case a partition for n-numbered mini-cells is masked through the masking process and then a single unit layer process is performed, a substrate may need a transport process and an alignment process only once.

Thus, the tandem solar cell and module and the manufacturing method thereof in another embodiment may ensure uniformity of unit layers, thereby improving photoelectric conversion efficiency, and may ensure improvement in productivity.

A plurality of tandem solar cells manufactured according to an aspect of the third embodiment may experience a modulation process where the plurality of tandem solar cells are electrically connected in series or in parallel according to aspect to the first embodiment or the second embodiment, to be used as a solar cell module.

The present disclosure has been described with reference to the embodiments illustrated in the drawings. However, the disclosure is not limited to the embodiments and the drawings set forth herein. Further, various modifications may be made by one having ordinary skill in the art within the scope of the invention as defined by the claims.

## Claims

1. A solar cell module (200), comprising:
- a solar cell (150) comprising a perovskite solar cell;
- a first encapsulating material (131) and a second encapsulating material (132) configured to seal the solar cell (150), wherein the first encapsulating material (131) is placed on a light receiving surface;
- a first protective member (110) disposed on the first encapsulating material (131);
- a second protective member (120) disposed on the second encapsulating material (132); and
- a third encapsulating material (133) disposed on lateral surfaces of the first encapsulating material (131) and the second encapsulating material (132), and disposed between the first protective member (110) and the second protective member (120),
wherein the first protective member (110) is made of a light transmitting material that is light permeable, and the second protective member (120) is implemented as a sheet made of a light transmitting material or a reflective material,
- wherein a water vapor transmission rate, WVTR, of the third encapsulating material (133) is lower than that of the second encapsulating material (132), and a WVTR of the second encapsulating material (132) is lower than that of the first encapsulating material (131),
- wherein the first and second encapsulating materials (131, 132) comprise an insulating material having light transmittance and adhesion, and
- wherein the first encapsulating material (131) has a higher light transmittance or higher light transmission than the second encapsulating material (132).

2. The solar cell module (200) of claim 1,
- wherein the second encapsulating material (132) is olefin-based resin and the third encapsulating material (133) includes butyl rubber.

3. The solar cell module (200) of any one of claims 1 to 2,
- wherein the first protective member (110) includes glass, and the second protective member (120) is a TPT, Tedlar/PET/Tedlar,-type or includes a poly vinylidene fluoride, PVDF, resin layer formed on at least one surface of a glass film, a metallic film such as an aluminum film and the like, or a base film.

4. The solar cell module (200) of any one of claims 1 to 3, comprising:
- a frame (190) disposed an edge of the solar cell module (200); and
- an edge sealant (180) disposed between the frame (190) and the third encapsulating material (133).

5. The solar cell module (200) of any one of claims 1 to 4,
- wherein the module (200) further comprises a frame (190) surrounding the first protective member (110), the second protective member (120) and the third encapsulating material (133) and a width of the frame in a direction of a flat surface of the solar cell (150) is wider than a width of the third encapsulating material (133).

6. The solar cell module (200) of any one of claims 1 to 5,
- wherein the first encapsulating material (131) comprises ethylene-vinyl acetate copolymer, EVA, resin in which the amount of the vinyl acetate is between 10 wt.% and 30 wt.%.

## Patentansprüche

1. Solarzellenmodul (200), umfassend:
- eine Solarzelle (150), umfassend eine Perowskit-Solarzelle;
- ein erstes Verkapselungsmaterial (131) und ein zweites Verkapselungsmaterial (132), die konfiguriert sind, um die Solarzelle (150) abzudichten, wobei das erste Verkapselungsmaterial (131) auf einer lichtempfangenden Oberfläche platziert ist;
- ein erstes Schutzelement (110), das auf dem ersten Verkapselungsmaterial (131) angeordnet ist;
- ein zweites Schutzelement (120), das auf dem zweiten Verkapselungsmaterial (132) angeordnet ist; und
- ein drittes Verkapselungsmaterial (133), das auf Seitenoberflächen des ersten Verkapselungsmaterials (131) und des zweiten Verkapselungsmaterials (132) angeordnet ist und zwischen dem ersten Schutzelement (110) und dem zweiten Schutzelement (120) angeordnet ist, wobei das erste Schutzelement (110) besteht aus einem lichtdurchlässigen Material das lichtdurchlässig ist, und das zweite Schutzelement (120) als eine Lage aus einem lichtdurchlässigen Material oder einem reflektierenden Material implementiert ist,
- wobei eine Wasserdampfdurchgangsrate, WVTR, des dritten Verkapselungsmaterials (133) niedriger als die des zweiten Verkapselungsmaterials (132) ist, und eine WVTR des zweiten Verkapselungsmaterials (132) niedriger als die des ersten Verkapselungsmaterials (131) ist,
- wobei das erste und das zweite Verkapselungsmaterial (131, 132) ein Isoliermaterial umfassen, das Lichtdurchlässigkeit und Haftung aufweist, und
- wobei das erste Verkapselungsmaterial (131) eine höhere Lichtdurchlässigkeit oder einen höheren Lichtdurchgang als das zweite Verkapselungsmaterial (132) aufweist.

2. Solarzellenmodul (200) nach Anspruch 1,
- wobei das zweite Verkapselungsmaterial (132) ein Olefin-basiertes Harz ist und das dritte Verkapselungsmaterial (133) Butylkautschuk einschließt.

3. Solarzellenmodul (200) nach einem der Ansprüche 1 bis 2,
- wobei das erste Schutzelement (110) Glas einschließt und das zweite Schutzelement (120) eine TPT-Art, Tedlar/PET/Tedlar-Art, ist oder eine Polyvinylidenfluoridharzschicht, PVDF-Harzschicht, einschließt, die auf mindestens einer Oberfläche eines Glasfilms, eines metallischen Films wie einem Aluminiumfilm und dergleichen, oder eines Basisfilms ausgebildet ist.

4. Solarzellenmodul (200) nach einem der Ansprüche 1 bis 3, umfassend:
- einen Rahmen (190), der an eine Kante des Solarzellenmoduls (200) angeordnet ist; und
- ein Randabdichtmittel (180), das zwischen dem Rahmen (190) und dem dritten Verkapselungsmaterial (133) angeordnet ist.

5. Solarzellenmodul (200) nach einem der Ansprüche 1 bis 4,
- wobei das Modul (200) ferner einen Rahmen (190) umfasst, der das erste Schutzelement (110), das zweite Schutzelement (120) und das dritte Verkapselungsmaterial (133) umgibt und eine Breite des Rahmens in einer Richtung einer flachen Oberfläche der Solarzelle (150) breiter als eine Breite des dritten Verkapselungsmaterials (133) ist.

6. Solarzellenmodul (200) nach einem der Ansprüche 1 bis 5,
- wobei das erste Verkapselungsmaterial (131) Ethylen-Vinylacetatcopolymerharz, EVA-Harz, umfasst, in dem die Menge des Vinylacetats zwischen 10 Gew.-% und 30 Gew.-% liegt.

## Revendications

1. Module de cellules solaires (200), comprenant :
- une cellule solaire (150) comprenant une cellule solaire en pérovskite ;
- un premier matériau d'encapsulation (131) et un deuxième matériau d'encapsulation (132) configurés pour sceller la cellule solaire (150), le premier matériau d'encapsulation (131) étant placé sur une surface réceptrice de lumière ;
- un premier élément de protection (110) disposé sur le premier matériau d'encapsulation (131) ; un second élément de protection (120) disposé sur le deuxième matériau d'encapsulation ; et
- un troisième matériau d'encapsulation (133) disposé sur des surfaces latérales du premier matériau d'encapsulation (131) et du deuxième matériau d'encapsulation (132), et disposé entre le premier élément de protection (110) et le second élément de protection (120), dans lequel le premier élément de protection (110) est constitué d'un matériau transmettant la lumière qui est perméable à la lumière, et le second élément de protection (120) étant constitué d'une feuille en matériau transmettant la lumière ou d'un matériau réfléchissant,
- dans lequel le taux de transmission de la vapeur d'eau, WVTR, du troisième matériau d'encapsulation (133), est inferieur à celui du deuxième matériau d'encapsulation (132), et le WVTR du deuxième matériau d'encapsulation (132) est inférieur à celui du premier matériau d'encapsulation (131),
- dans lequel les premier et deuxième matériaux d'encapsulation (131, 132) comprennent un matériau isolant ayant une transmittance de lumière et une adhérence, et
- dans lequel le premier matériau d'encapsulation (131) présente une transmittance de lumière plus élevée ou une transmission de lumière plus élevée que le deuxième matériau d'encapsulation (132).

2. Module de cellules solaires (200) selon la revendication 1,
- dans lequel le deuxième matériau d'encapsulation (132) est une résine à base d'oléfine et le troisième matériau d'encapsulation (133) comprend du caoutchouc butyle.

3. Module de cellules solaires (200) selon l'une quelconque des revendication 1 à 2,
- dans lequel le premier élément de protection (110) comprend du verre, et le second élément de protection (120) est de type TPT, Tedlar/PET/Tedlar, ou comprend une couche de résine de polyfluorure de vinylidène (PVDF) formée sur au moins une surface d'un film de verre, d'un film métallique, tel qu'un film d'aluminium ou similaire, ou d'un film de base.

4. Module de cellules solaires (200) selon l'une quelconque des revendication 1 à 3, comprenant :
- un cadre (190) disposé sur un bord du module de cellules solaires (200) ; et
- un scellant de bord (180) disposé entre le cadre (190) et le troisième matériau d'encapsulation (133).

5. Module de cellules solaires (200) selon l'une quelconque des revendication 1 à 4,
- dans lequel le module (200) comprend, en outre, un cadre (190) entourant le premier élément de protection (110), le second élément de protection (120) et le troisième matériau d'encapsulation (133), et une largeur du cadre dans une direction d'une surface plane de la cellule solaire (150) est supérieure à une largeur du troisième matériau d'encapsulation (133).

6. Module de cellules solaires (200) selon l'une quelconque des revendication 1 à 5,
- dans lequel le premier matériau d'encapsulation (131) comprend un copolymère d'éthylène-acétate de vinyle, EVA, dans lequel la quantité d'acétate de vinyle est comprise entre 10 % en poids et 30 % en poids.
